# EUROPEAN PATENT SPECIFICATION

(11) **EP 4 209 280 B1**
(45) Date of publication and mention of the grant of the patent: **25.02.2026**
(21) Application number: 21864052.2
(22) Date of filing: 05.08.2021
(51) Int. Cl.: B05D 1/26, B05D 3/00, B05D 7/24, B05C 5/00, B41J 2/01, B41J 2/21, B41J 2/205, G06K 15/10

(54) **METHOD OF PATTERN FORMATION**
VERFAHREN ZUR MUSTERBILDUNG
PROCÉDÉ DE FORMATION DE MOTIFS

(30) Priority: 03.09.2020 JP 2020147933
(43) Date of publication of application: 12.07.2023
(73) Proprietor: KONICA MINOLTA, INC., Tokyo 100-7015 (JP)
(72) Inventor: YAMAUCHI, Masayoshi, Tokyo 100-7015 (JP)
(74) Representative: Gille Hrabal Partnerschaftsgesellschaft mbB Patentanwälte
(86) International application number: PCT/JP2021/029174
(87) International publication number: WO 2022/049994

(56) References cited:
- EP-A1- 3 434 741
- JP-A- 2006 150 788
- JP-A- 2006 289 722
- JP-A- 2009 230 018
- JP-A- 2015 033 657
- JP-A- 2019 005 946
- JP-A- 2019 217 669
- US-A1- 2007 291 076
- US-B2- 9 050 821

## Description

### Technical Field

The present invention relates to a method of pattern formation. More specifically, the present invention relates to a method of pattern formation by inkjet printing method, which is highly precise and free from streaks and speckles.

### Background Art

In recent years, research and development of technology to form patterns on electronic devices by an inkjet printing method using ink containing functional materials (hereinafter also simply referred to as an "inkjet method") has been conducted.

Patent document 1 discloses a method of manufacturing a multilayered wiring board having an interlayer insulating layer by a droplet ejection method (inkjet method). However, depending on the combination of the board and ink, problems such as generation of bulges have occurred. Also, when patterns are formed across different boards, problems of ink flowing to the side of the board with higher wettability occurred due to differences in the wettability of ink on the boards.

Patent document 2 discloses a method of applying droplets of insulating layer forming material at different distances from the edge depending on the wettability of the underlying substrate on the board. However, problems of ink flow occurred when the underlying substrates had significantly different wetting characteristics. Also, problems of ink flow occurred when a pattern is formed across a board with uneven surfaces.

Patent document 3 discloses an invention by the inventor of the present application to solve the above problems by reciting viscosity of the ink during ejection and after landing in the pattern formation of the insulating layer by the inkjet method. However, the insulating layer forming ink having a phase change mechanism used there has a high dot fixation property after landing. Therefore, there was room for further improvement regarding the occurrence of streak-like irregularities in the scan direction.

Also, Patent Document 4 discloses that, with an inkjet one-pass printer, multiple adjacent pixels are made into a group, and the liquid droplet amount ejected at a certain pixel in the group is adjusted, thereby reducing the number of pixels ejected in a group and suppressing the gloss streak in the conveying direction. However, we found in our study that when this method is applied in a multi-pass system, streaks in the direction perpendicular to the conveying direction are observed.

Multi-pass printing is mainly used for high-resolution printing for the purpose of high-precision pattern printing. Multi-pass printing tends to cause streak-like irregularities due to the long time between passes.

When forming an insulating layer or a conductive layer, the streak-like irregularities cause not only appearance problems but also serious problems such as insulation irregularities and conductivity irregularities.

Furthermore, when a pattern is formed on a convex portion of a board, there is also the problem of insufficient coverage of the pattern at the step, resulting in insulation and conductivity defects.
**Prior art documents** EP 3434741A **and** US 9050821B **both disclose inkjet printing method which have some overlap with the method of the current invention.**

### Citation List

### Patent Literature

Patent Document 1: JP 2003-309369A
Patent Document 2: JP 2010-231287A
Patent Document 3: WO 2015/002316A1
Patent Document 4: JP 2012-162057A

### Summary of Invention

### Technical Problem

The present invention has been made in view of the above problems and circumstances, and the problem to be solved relates to providing a method of pattern formation by an inkjet printing method that provides high precision, no streaks or speckles, uniform insulating and conductive properties even when using inks containing functional materials such as insulators and conductors, and good adhesion of the coating layer.

### Solution to Problem

In the process of studying the causes of the above problems, the present inventor has found that the causes of streaks and speckles relate to the periodicity or randomness of the position at which ink droplets land, and has arrived at the present invention.
The invention is as set out in the appended set of claims.

### Advantageous Effects of Invention

By the above means of the present invention, it is possible to provide a method of pattern formation by an inkjet printing method that provides high precision, no streaks or speckles, uniform insulating and conductive properties even when using inks containing functional materials such as insulators and conductors, and good adhesion of the coating layer.

The mechanism of the effect or mechanism of action of the present invention is not clear, but is inferred as follows.

By using an ink whose ratio η2/η1 of viscosity η2 at a temperature upon landing to viscosity η1 at a temperature upon ejection is 100 or more, for example, it is easy to obtain stability of ink ejection, and thus ink can be applied to the board with high precision. It is also estimated that the ink applied to the board facilitates rapid fixation (pinning) of the contact line to the board. It is presumed that the ink is prevented from flowing. It is also considered that the generation of bulges will be suppressed, and the formation of lines of uniform width and highly precise patterns across different components is possible.

The liquid amount of the ink that is used to form the coating layer of the dot constituting the pattern to be formed on the board is controlled so as not to have a certain periodicity with neighboring dots and such that the coating layer of the pattern is not entirely even. This can suppress the occurrence of streaks and speckles in the scan direction and eliminate the non-uniformity of insulation and conductive properties due to the streaks and speckles.

Then, it is easy to print patterns with high resolution and high precision by using the multi-pass method including multiple movements perpendicular to or parallel to a nozzle row direction of an ink ejecting device having multiple nozzle holes aligned in a row, in which ink droplets are ejected from the nozzles onto the board as the print medium to form a pattern.

The method of pattern formation by the inkjet printing method of the present invention will be described in contrast to conventional methods of pattern formation.

For example, we will explain the method of printing using an inkjet print head with a resolution of 600 dpi for image data in multiple movements (passses) by moving the inkjet print head in the nozzle row direction so that the output resolution is 1200 dpi.

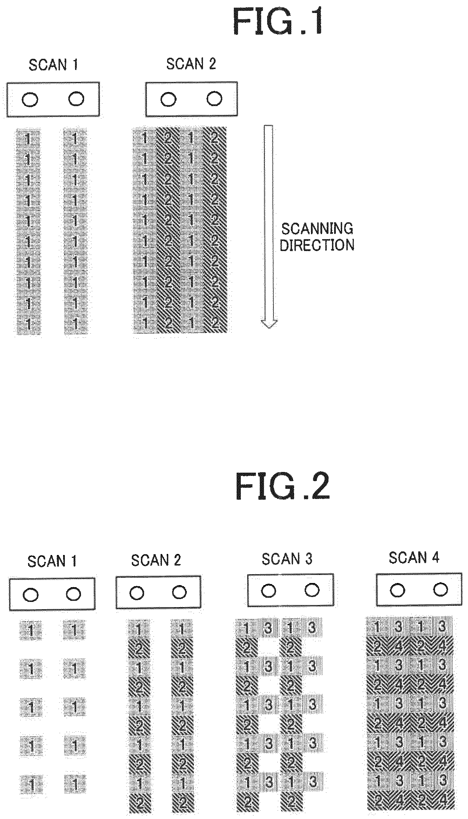

The inkjet printing method illustrated in Figure 1 is known as a block method. The same nozzles are used for printing in the first scan in the conveying direction, and printing at 1200 dpi is completed in the second scan after the head is moved in the nozzle row direction by a distance corresponding to the output resolution of 1200 dpi (21.2 µm).

In this case, as shown in FIG. 1, landing of droplets is done in "Scan 1" and "Scan 2" in succession, and streaks are likely to occur in the conveying direction.

The inkjet printing method illustrated in FIG. 2 is known as the interleaving method, in which the nozzle is used to print every second pixel in the first scan in the conveying direction, the pixels between those printed in the first scan are printed in the second scan in the conveying direction, the head is then moved in the nozzle row direction by a distance corresponding to the resolution of 1200 dpi (21.2 µm), and the third and fourth scans are done in the same manner such that the printing at 1200 dpi is completed.

Also in this case, as illustrated in the figure, the order of landing is periodic, such as "Scan 1" to "Scan 4," and streaks are likely to occur.

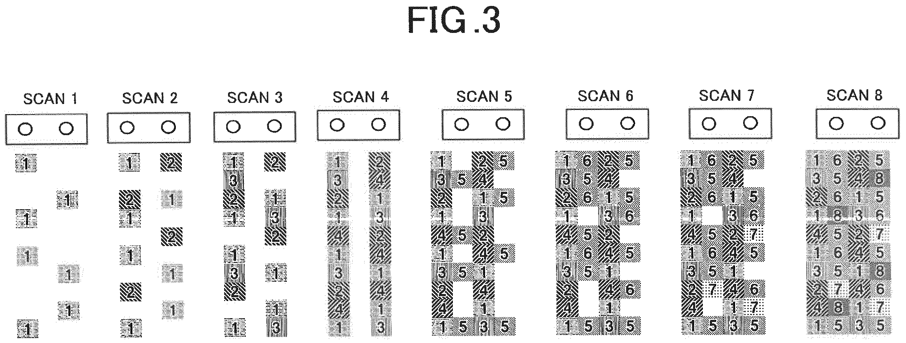

The inkjet printing method shown in FIG. 3 is the random multi-pass method related to the present invention including landing in a so-called "random" manner. Printing at 1200 dpi is completed in a total of 8 passes so that the order of landing is random. The number of passes may be increased. The number of passes may also be increased by further thinning in the conveying direction.

According to this random multi-pass method, droplets land randomly, and thus streaks become less apparent.

The term "random" as used in the present invention refers to a state in which randomness or unpredictability having regularity such as overall identity or periodicity is recognized with respect to the liquid amount of dots or the mutual positional relationship of dots in the method of pattern formation under the condition of control within the following conditions. Specifically, "random" refers to the state illustrated, for example, in FIG. 3.

The reason for the effect of the present invention can be inferred from the above contrasting example. Less streaks and irregularities are considered to appear as a whole because there is no periodicity between adjacent pixels or dots due to random landing positions and order of ink droplets in the image printed in the method of pattern formation of the present invention.

### Brief Description of Drawings

[FIG. 1] A schematic diagram illustrating a method of pattern formation using a block method.
[FIG. 2] A schematic diagram illustrating a method of pattern formation using an interleaving method.
[FIG. 3] A schematic diagram illustrating a method of pattern formation using a random multi-pass method related to the present invention.
[FIG. 4] A diagram showing image data with uniform shade or density of each pixel.
[FIG. 5] A diagram showing image data with a certain periodicity in shade or density of each pixel.
[FIG. 6] A diagram showing a gray image of 256 shades that does not have a certain periodicity with neighboring pixels.
[FIG. 7] An image of the liquid amount distribution of dots formed by printing based on the image data in FIG. 6.
[FIG. 8A] A schematic diagram (front view) of an inkjet printing device using the multi-pass method.
[FIG. 8B] A schematic diagram (top view) of an inkjet printing device using the multi-pass method.
[FIG. 9] A schematic diagram illustrating a method of block printing at 1200 dpi using a single inkjet print head with a resolution of 600 dpi.
[FIG. 10] A diagram showing image data used in the random multi-pass method where the liquid amount of the formed dots is uniform.
[FIG. 11] A schematic diagram illustrating a method of printing at 1200 dpi including random landing using a single inkjet print head with a resolution of 600 dpi.
[FIG. 12] A diagram showing image data of a solid portion of Example 1.
[FIG. 13] An optical microscope photograph of a printed material 1 at a magnification of 100.
[FIG. 14] A diagram showing a printing method of Example 2.
[FIG. 15] A diagram showing image data of a solid portion of Example 2.
[FIG. 16] A diagram showing image data of a solid portion of Example 3.
[FIG. 17] An optical microscope photograph of a printed material 3 at a magnification of 100.
[FIG. 18] A diagram showing image data of a hollow circle of Example 3.
[FIG. 19] An optical microscope photograph of a hollow circle with a diameter of 500 µm of a printed material 3 at a magnification of 100.
[FIG. 20] A diagram showing image data of a hollow circle of Example 4.
[FIG. 21] An optical microscope photograph of a hollow circle with a diameter of 500 µm of a printed material 4 at a magnification of 100.
[FIG. 22] An enlarged schematic diagram of a printed wiring board with a Cu wiring pattern.
[FIG. 23] A diagram showing image data to be printed the printed wiring board of Example 5.
[FIG. 24] A diagram showing image data of a wiring portion of Example 6.
[FIG. 25] A diagram showing image data of a wiring portion of Example 7.
[FIG. 26] A diagram showing image data of a solid portion of Example 8.
[FIG. 27] An optical microscope photograph of a printed material 8 at a magnification of 100.
[FIG. 28] An optical microscope photograph of a printed material 9 (Comparative Example 1) at a magnification of 100.
[FIG. 29] A diagram illustrating a method of printing at a resolution of 2400 dpi using a single inkjet print head with a nozzle resolution of 600 dpi including random landing and division printing (number of image divisions: 2).
[FIG. 30A] A diagram illustrating a method of printing at a resolution of 2400 dpi using a single inkjet print head with a nozzle resolution of 600 dpi including random landing and division printing (number of image divisions: 4) (scan 1 to scan 8).
[FIG. 30B] A diagram illustrating a method of printing at a resolution of 2400 dpi using a single inkjet print head with a nozzle resolution of 600 dpi including random landing and division printing (number of image divisions: 4) (scan 9 to scan 16).
[FIG. 31] A diagram illustrating a method of printing at a resolution of 2400 dpi using a single inkjet print head with a nozzle resolution of 600 dpi including random landing.
[FIG. 32] A diagram illustrating a case where, in scan 1 and scan 5 in the method of printing at a resolution of 2400 dpi using a single inkjet print head with a nozzle resolution of 600 dpi including random landing and division printing (number of image divisions: 2), positions of dots where droplets ejected from the leftmost nozzle land are identical to the positions of dots where droplets ejected from the middle nozzle land.
[FIG. 33] A top view of an inkjet printing device 100 using the multi-pass method.
[FIG. 34] A diagram illustrating a method of printing with an inkjet printing device 1 (the head moves in the X direction and the board moves in the Y direction).
[FIG. 35] A diagram illustrating a method of printing with an inkjet printing device 100 (the head moves in the Y direction and the board moves in the X direction).
[FIG. 36] A diagram illustrating a method of printing with an inkjet printing device in which the board moves in both X and Y directions.

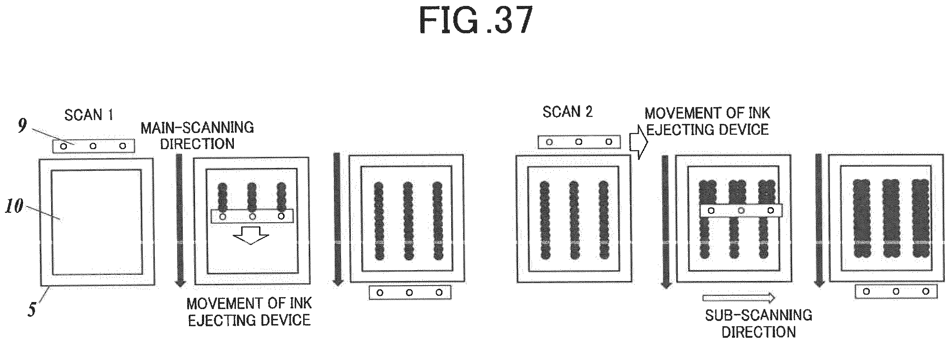

[FIG. 37] A diagram illustrating a method of printing with an inkjet printing device in which the head moves in both X and Y directions.
[FIG. 38] A diagram illustrating a method of bidirectional printing in which the ink ejecting device relatively moves back and forth in a main scanning direction and ejects ink droplets in both forward and backward passes.
[FIG. 39] A diagram illustrating a method of backward and forward printing, in which the ink ejecting device relatively moves in a forward direction and in an opposite direction in combination, with respect to a sub scanning direction.
[FIG. 40] A diagram illustrating a method of division printing at a resolution of 2400 dpi using four inkjet print heads with a nozzle resolution of 600 dpi.
[FIG. 41] A diagram illustrating a printing method when the direction of a nozzle column is not perpendicular to or parallel to either the X direction or the Y direction, but is at an angle.
[FIG. 42] A diagram illustrating a printing method when the direction of the ink ejecting device is not perpendicular to or parallel to either the X direction or the Y direction, but is at an angle.
[FIG. 43] A diagram illustrating a printing method including random landing at a resolution of 2400 dpi using a single inkjet print head with a nozzle resolution of 600 dpi using multi-shaded image data.
[FIG. 44] A diagram illustrating a method of printing at a resolution of 2400 dpi including interleaving and division printing using a single inkjet print head with a nozzle resolution of 600 dpi.

### Description of Embodiments

The method of pattern formation of the present invention is a method of pattern formation by an inkjet printing method based on image data of a pattern, the pattern formation including movements perpendicular to a nozzle column direction of an ink ejecting device in which multiple nozzle holes are arranged in a column, movements parallel to the nozzle column direction, and ejection of a droplet of an ink from a nozzle onto a board as a print medium, the method including: using an ink having a ratio η2/η1 equal to or more than 100, the η1 being a viscosity at a temperature upon ejection, the η2 being a viscosity at a temperature upon landing; and at least one of: (1) controlling a liquid amount of the ink used to form a coating layer of a dot constituting the pattern to be formed on the board corresponding to shade or density of each pixel constituting the image data of the pattern so as not to have a certain periodicity with neighboring dots and such that the coating layer of the pattern is not entirely even; and (2) multiple times of landing of the droplet of the ink that is used to form a coating layer of a dot constituting the pattern to be formed on the board, and controlling a position of the dot where the droplet lands so as not to be in the order of a row or a column of an array of pixels constituting the image data, and so as not to have a certain periodicity.

This is a technical feature common to or corresponding to the following embodiments.

The method of pattern formation of the present invention also is a method of pattern formation by an inkjet printing method based on image data of a pattern, the pattern formation including movements of an ink ejecting device having multiple nozzle holes or a board as a print medium and ejection of a droplet of an ink from a nozzle of the ink ejecting device onto the board as the print medium, the method including: using an ink having a ratio η2/η1 equal to or more than 100, the η1 being a viscosity at a temperature upon ejection, the η2 being a viscosity at a temperature upon landing; multiple times of landing of the droplet of the ink that is used to form a coating layer of a dot constituting the pattern to be formed on the board, and controlling a position of the dot where the droplet lands so as not to have a certain periodicity in a main scanning direction or in a sub scanning direction of the ink ejecting device, and so as not to be successive in the main scanning direction.

As an embodiment of the method of pattern formation of the present invention described in (3) above, from the viewpoint of preventing streaks and speckles, it is preferable to divide the image data of the pattern into a plurality of pieces and to overprint the divided image data sequentially such that respective pixels do not overlap when overprinted and such that the positions of the dots on which the droplets land do not have a certain periodicity in the main scanning direction or the sub scanning direction of the ink ejecting device, or are not successive in the main scanning direction.

As an embodiment of the method of pattern formation of the present invention described in (3) above, from the viewpoint of preventing streaks and speckles, the ink ejecting device preferably moves bidirectionally relative to the main scanning direction and ejects ink droplets in both directions.

As an embodiment of the method of pattern formation of the present invention described in (3) above, from the viewpoint of preventing streaks and speckles, the ink ejecting device preferably moves backward and forward in combination, relative to the sub-scanning direction.

As an embodiment of the method of pattern formation of the present invention described in (3) above, from the viewpoint of preventing streaks and speckles, the liquid amount of the ink used to form the coating layer of dots constituting the pattern to be formed on the board is preferably controlled corresponding to the shade or density of each pixel constituting the image data of the pattern, so as not to have a certain periodicity with the neighboring dots and such that the coating layer of the pattern is not entirely even.

As an embodiment of the present invention, from the viewpoint of preventing streaks and speckles, preferably, control is made such that a liquid amount of the ink per dot that form an inner edge of a patterned portion at a boundary between the patterned portion and a non-patterned portion formed on the board is substantially the same.

As an embodiment of the present invention, from the viewpoint of preventing occurrence of insulation and conductive defects, preferably, control is made such that a liquid amount of the ink per dot that form an edge of a convex portion of the board is substantially the same.

As an embodiment of the present invention, from the viewpoint of preventing occurrence of insulation and conductive defects, preferably, control is made such that a liquid amount of the ink per dot that form an outer edge of a boundary between an inside and an outside of a bottom of a convex portion of the board is more than a liquid amount of the ink per dot that form an edge of the convex portion.

As an embodiment of the present invention, from the viewpoint of preventing occurrence of insulation and conductive defects, preferably, control is made such that a liquid amount of a dot that forms an outer edge surface at a boundary between an inside and an outside of a bottom surface of a convex portion of the board varies continuously from a surface in contact with the convex portion to a surface in an outward direction.

As an embodiment of the present invention, from the viewpoint of preventing occurrence of insulation and conductive defects, preferably, control is made such that an average thickness of the coating layer of the dot constituting the pattern is 15 µm or more.

As an embodiment of the present invention, from the viewpoint of preventing streaks and speckles, preferably, a liquid amount of the ink that lands and forms a coating layer of the dot constituting the pattern is changed in multiple levels.

As an embodiment of the present invention, from the viewpoint of formability of highly precise patterns, preferably, the ink is one of a hot-melt type ink, a gelled type ink, and a thixotropic type ink.

As an embodiment of the present invention, from the viewpoint of application suited to the purpose of the invention, for example, from the viewpoint that the problems to be solved by the present invention are those when circuit patterns are protected by an insulating layer, preferably, the ink is a solder resist ink.

The method of pattern formation of the present invention is preferably applied to an inkjet printing device.

Hereinafter, the present invention, its components, and the embodiments and modes to carry out the present invention will be described in detail. In the present application, "to" with numerical values before and after it is used in the sense that the numerical values are included as a lower limit and an upper limit.

### 1 Outline of the Method of Pattern Formation of the Present Invention

The method of pattern formation of the present invention utilizes an inkjet printing method based on image data of a pattern. The method includes multiple movements perpendicular to or parallel to a nozzle row direction of an ink ejecting device having multiple nozzle holes aligned in a row, and ink droplets are ejected from the nozzles onto the board as the print medium to form a pattern. The ink has the ratio η2/η1 of the viscosity η2 at a temperature upon landing to the viscosity η1 at a temperature upon ejection is 100 or more. The method also includes at least:
(1) controlling a liquid amount of the ink used to form a coating layer of a dot constituting the pattern to be formed on the board corresponding to shade or density of each pixel constituting the image data of the pattern so as not to have a certain periodicity with the neighboring dots and such that the coating layer of the pattern is not entirely even, or
(2) multiple times of landing of the droplet of the ink that is used to form a coating layer of a dot constituting the pattern to be formed on the board, and controlling a position of the dot where the droplet lands so as not to be in the order of a row or a column of an array of pixels constituting the image data, and so as not to have a certain periodicity..

Also, (3) in the method of pattern formation utilizing an inkjet printing method based on image data of a pattern, an ink ejecting device having a plurality of nozzle holes or a board as a print medium moves a plurality of times. In a method of forming a pattern including ejection of droplets of ink from the nozzles of the ink ejecting device onto the board as the print medium, the ink to be used has the ratio η2/η1 of the viscosity η2 at a temperature upon landing to the viscosity η1 at a temperature upon ejection is 100 or more, the droplets of the ink used to form the coating layer of dots constituting the pattern to be formed on the board land multiple times, and positions of the dots where the droplets land are controlled so as not to have a certain periodicity in the main scanning direction or in the sub scanning direction of the ink ejecting device and so as not to be successive in the main scanning direction.

The method of pattern formation used in the present invention uses the so called "multi-pass method" described above, which includes multiple movements perpendicular to or parallel to a nozzle row direction of an ink ejecting device having multiple nozzle holes aligned in a row, and ejection of ink droplets ejected from the nozzles onto the board as the print medium. Details of the devices used in the present invention are described below.

Regarding (3), the ink ejecting device having multiple nozzle holes or a board as a print medium moves multiple times, and a pattern is formed by ejecting ink droplets from the nozzles of the ink ejecting device onto the board as the print medium.

The ink used in the present invention has the ratio η2/η1 of the viscosity η2 at a temperature upon landing to the viscosity η1 at a temperature upon ejection is 100 or more. Details of the inks are described below.

In the following, embodiments and components of the present invention will be described one by one.

### 1.1 Method of Pattern Formation by Random Drop Multi-pass Method

The method of pattern formation according to the present invention is characterized in that the liquid amount of the ink used to form the coating layer of dots constituting the pattern to be formed on the board is controlled corresponding to the shade or density of each pixel constituting the image data of the pattern, so as not to have a certain periodicity with the neighboring dots and such that the coating layer of the pattern is not entirely even.

Here, "not even" means that the difference in liquid amount between individual dots is within the range of ±5%. Although the liquid amount of some dots is practically the same, dots of the same liquid amount are not aligned in a periodic manner.

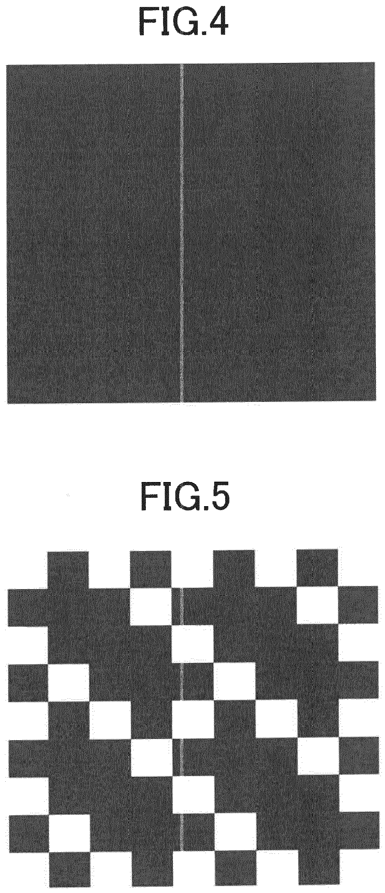

An example where the liquid amount of ink used to form a dot has a certain periodicity with adjacent dots is the case where pattern formation is performed through printing using image data having a certain periodicity in the shade or density of pixels, as shown in FIG. 4 and FIG. 5.

In the present specification, a method that satisfies the above control conditions is referred to as a "random drop multi-pass method."

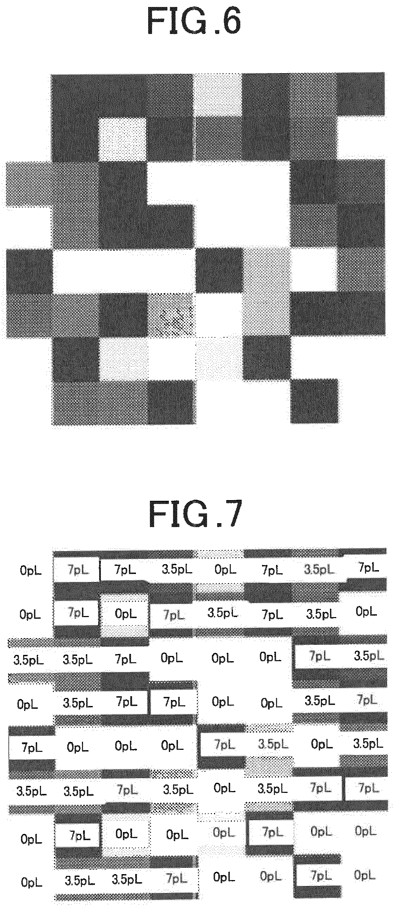

The term "random" as used in the present invention refers to a state in which randomness or unpredictability having regularity such as overall identity or periodicity is recognized with respect to the liquid amount of dots or the mutual positional relationship of dots in the method of pattern formation under the condition of control within the following conditions. Specifically, "random" refers to the state illustrated, for example, in FIG. 7.

In the present invention, a "dot" refers to the smallest unit of a pixel that constitutes an ink image formed on a print medium by the inkjet printing method, and is a portion of a coating layer formed with a single droplet of liquid ink. Therefore, a pixel in an ink image corresponding to one pixel in the image data to be printed may be formed of multiple dots (droplets).

In the following, an example of an embodiment of the method of pattern formation by a random drop multipassth method will be described. However, the method is not limited to the embodiment and mode of the following example.

The image data and liquid amount distribution of ink in the present embodiment will be explained.

In the random drop multi-pass method of the present invention, the liquid amount of the dot is changed corresponding to the shade or density of each pixel. Therefore, the image data for the random drop multi-pass method is preferably a gray image with 256 shades that does not have a certain periodicity with adjacent pixels, as shown in FIG. 6, for example.

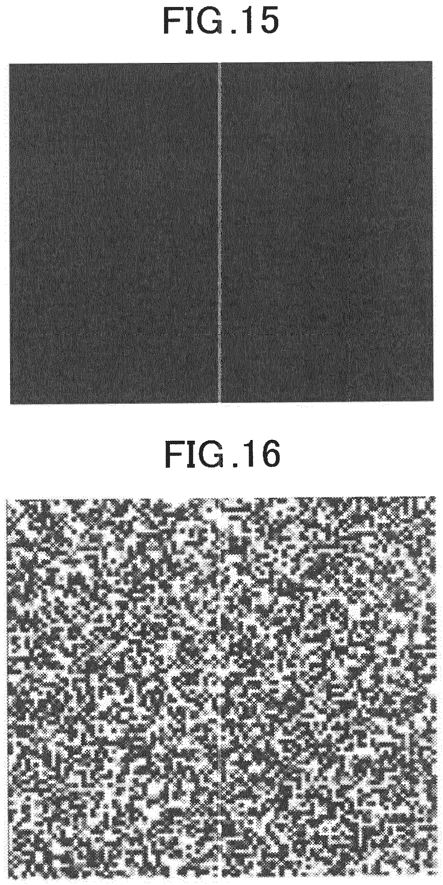

Multi-shaded random image data can be produced by image processing of a gray image. For example, a 30% gray image with 256 shades is processed with a noise filter using Adobe Photoshop, and random multi-shaded gray image data such as in FIG. 16 can be prepared.

Based on this multi-shaded image data, the liquid amount can be distributed, for example, 7 pL for the black portions of 0 to 86 shades, 3.5 pL for the gray portions of 87 to 172 shades, and 0 pL for the white portions of 173 to 255 shades.

FIG. 7 is an image of the liquid amount distribution of dots printed and formed based on the image data in FIG. 6. Random distribution of liquid amount prevents streaks and speckles.

Next, the inkjet printing device and printing method in the present embodiment will be explained.

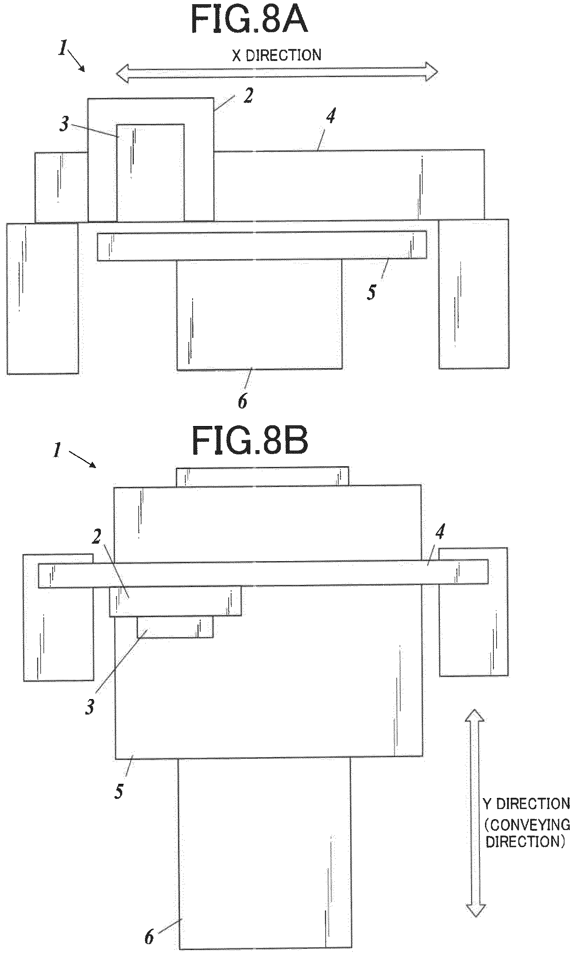

FIG. 8 is a schematic diagram of the inkjet printing (print) device 1 in the present embodiment. The details of the device are described later. In the device illustrated in FIG. 8, a carriage 2 with an inkjet print head 3 of 600 dpi resolution that ejects ink is mounted on a linear stage 4 along the X direction, and the head 3 moves in the X direction. A table 5 on which the board is placed is mounted on the linear stage 6 along the Y direction and moves in the Y direction (conveying direction).

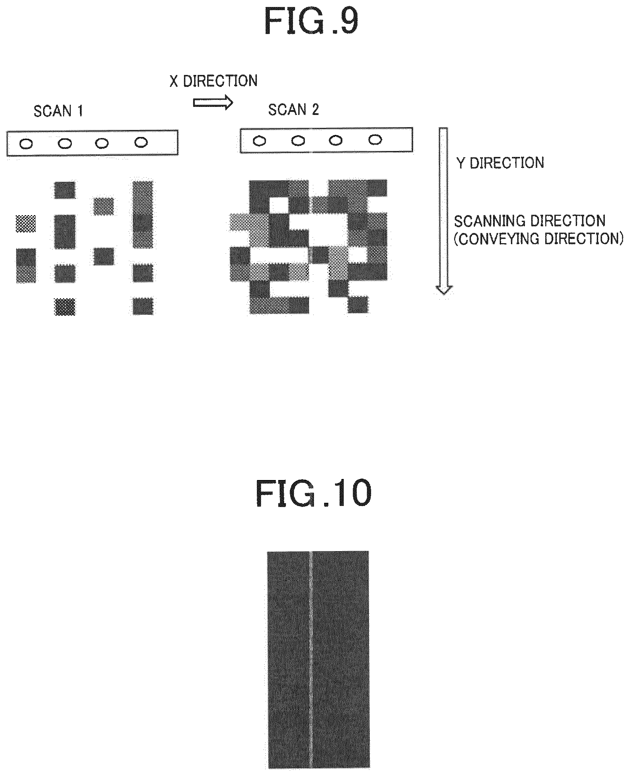

Pattern formation by the random drop multi-pass method in the present embodiment can be performed using block printing. FIG. 9 illustrates the method of block printing at 1200 dpi using a single inkjet print head with a resolution of 600 dpi.

The inkjet print head 3 illustrated in FIG. 8 moves in the Y direction (conveying direction) and performs printing with the liquid amount distributed according to the image data for Scan 1. After that, the head moves in the X direction by 21.2 µm (corresponding to one pixel of 1200 dpi) and performs printing with the liquid amount distributed according to the image data for Scan 2, and printing at 1200 dpi is completed.

### 1.2 Method of Pattern Formation by Random Multi-pass Method (A)

In the embodiment of the present invention, preferably, the droplets of the ink used to form the coating layer of dots constituting the pattern to be formed on the board land multiple times, and positions of dots where the droplets land are controlled so as not to be in accordance with the order of the rows and columns of the array of the pixels constituting the image data, and not to have a certain periodicity.

In the present specification, a method that satisfies the above control conditions is referred to as a "random multi-pass method (A)."

In the following, an example of an embodiment of the method of pattern formation by a random multi-pass method (A) will be described. However, the method is not limited to the embodiment and mode of the following example.

FIG. 10 is image data used in the random multi-pass method, and the dots are each formed with the same liquid amount. Alternatively, multi-shaded random image data as in FIG. 6, which is used in the random multi-pass method, may be used to form dots with respective different liquid amounts.

Landing of ink in the present embodiments will be explained.

In Scan 1, dots are formed so as not to be successive in the direction of rows or columns of the array, but to land at intervals, which are not constant. After Scan 1, dots are formed in the same manner at positions where no dots have been formed, so that dots do not overlap. The number of dots formed in each scan does not have to be constant.

The number of scans may be further increased.

Next, the printing method in the present embodiment will be described.

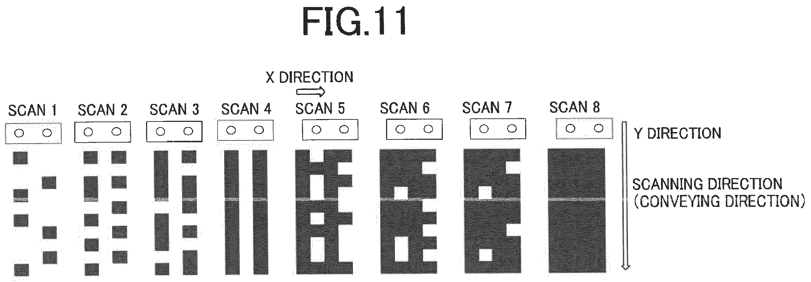

FIG. 11 illustrates a method of printing at 1200 dpi with random landing using one inkjet print head with a resolution of 600 dpi.

In the pattern formation by the random multi-pass method in the present embodiment illustrated in FIG. 3, the inkjet print head performs printing with four scans in the Y direction (conveying direction) as shown in FIG. 11, moves in the X direction by 21.2 µm (corresponding to one pixel at 1200 dpi), and performs printing again with four scans in the Y direction. In this way, printing is completed in a total of eight movements (passes) (see FIG. 8 for the device).

### 1.3 Method of Pattern Formation by Random multi-pass Method (B)

In the embodiment of the present invention, in the method of pattern formation utilizing an inkjet printing method based on image data of a pattern, an ink ejecting device having a plurality of nozzle holes or a board as a print medium moves a plurality of times. In a method of forming a pattern including ejection of droplets of ink from the nozzles of the ink ejecting device onto the board as the print medium, the ink to be used has the ratio η2/η1 of the viscosity η2 at a temperature upon landing to the viscosity η1 at a temperature upon ejection is 100 or more, the droplets of the ink used to form the coating layer of dots constituting the pattern to be formed on the board land multiple times, and positions of the dots where the droplets land are controlled so as not to have a certain periodicity in the main scanning direction or in the sub scanning direction of the ink ejecting device and so as not to be successive in the main scanning direction.

In the present specification, a method that satisfies the above control conditions is referred to as a "random multi-pass method (B)."

In the following, an example of an embodiment of the method of pattern formation by a random multi-pass method (B) will be described. However, the method is not limited to the embodiment and mode of the following example.

The method of pattern formation using the random multi-pass method (A) described in 1.2 includes multiple movements perpendicular to or parallel to a nozzle row direction of an ink ejecting device having multiple nozzle holes aligned in a row, and ejection of ink droplets from the nozzles onto the board as the print medium to form a pattern. However, in the present embodiment, the method of pattern formation includes multiple movements of the ink ejecting device having multiple nozzle holes or the board as the print media, and ejection of ink droplets from the nozzles of the ink ejecting device onto the board as the print media.

Although the details are described later, further study by the inventor has revealed the following. The main scanning direction and sub scanning direction of the ink ejecting device need not be perpendicular or parallel to the nozzle row. Streaks and irregularities are less likely to occur whether only one of the ink ejecting device and the board as the print media moves to form a pattern or both of them move to form a pattern.

In the method of pattern formation using the random multi-pass method (A) described in 1.2, the positions of the dots where the droplets land are controlled so as not to be in accordance with the order of the rows and columns of the array of the pixels constituting the image data, and not to have a certain periodicity. However, in the present embodiment, the positions are controlled so as not to have a certain periodicity in the main scanning direction or in the sub scanning direction of the ink ejecting device and so as not to be successive in the main scanning direction. In other words, according to the control so that there is no certain periodicity in the main scanning direction and sub scanning direction of the ink ejecting device and furthermore, there is no successivity in the main scanning direction, streaks and irregularities are less likely to occur even if there is partial successivity with respect to the sub scanning direction.

### 1.3.1 Division Printing

As an embodiment of the present invention, preferably, the image data of the pattern is preferably divided into multiple pieces to be sequentially overprinted, so that individual pixels do not overlap when the divided image data pieces are overprinted, and the positions of the dots where the droplets land do not have a certain periodicity in the main scanning direction or in the sub scanning direction of the ink ejecting device and are not successive in the main scanning direction.

In the present document, a printing method that satisfies the above control conditions is referred to as "division printing."

In the following, an example of an embodiment of the method of pattern formation by the division printing will be described. However, the method is not limited to the embodiment and mode of the following example.

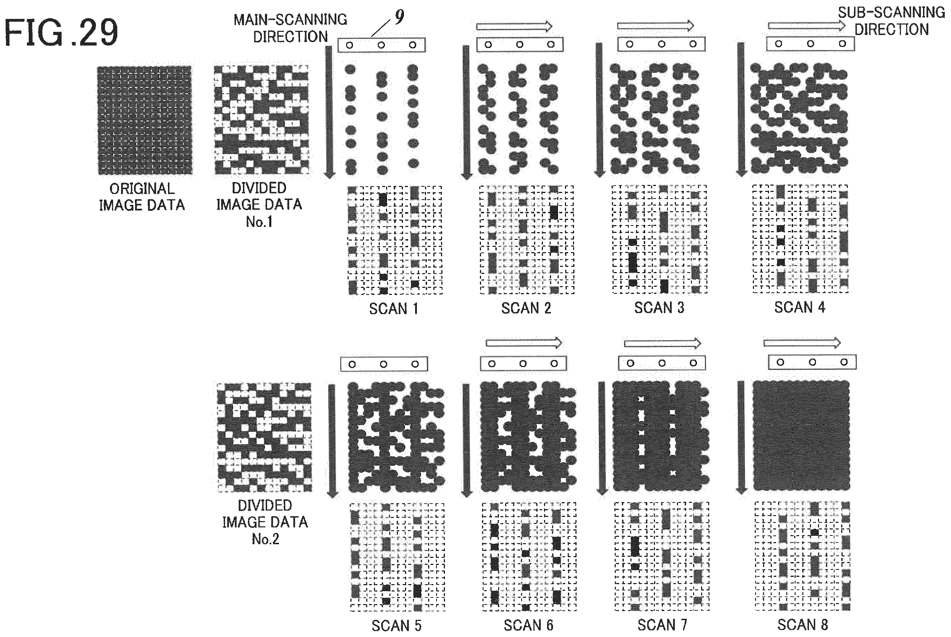

FIG. 29 illustrates a method of printing at a resolution of 2400 dpi using a single inkjet print head with a nozzle resolution of 600 dpi including random landing and division printing. In FIG. 29, original image data in which the dots are formed with the liquid amount is used. However, as in FIG. 6, multi-shaded random original image data may be used and the dots may be formed with different liquid amounts.

In the division printing, the original image data is divided into two pieces to prepare the division image data, and then the pieces of the division image data are overprinted. Therefore, the divided image data is prepared such that the pixels do not overlap when overprinted. In addition, the division image data is prepared such that the positions of the dots on which the droplets are to land do not have a certain periodicity in the main scanning direction and the sub scanning direction of the ink ejecting device and are not successive in the main scanning direction.

The divided image data can be prepared using image processing software such as Photoshop 2020 by Adobe. For example, a gray image is processed into a monochrome 2-shade image using the error diffusion method or the like with Photoshop, and random black and white images are prepared. Next, the color tones of the images are inverted to produce images with black and white inverted. The resulting two images are divided images of solid black data in which random landings do not overlap.

In the following, the division printing is explained with comparison of FIGS. 29, 30, and 31.

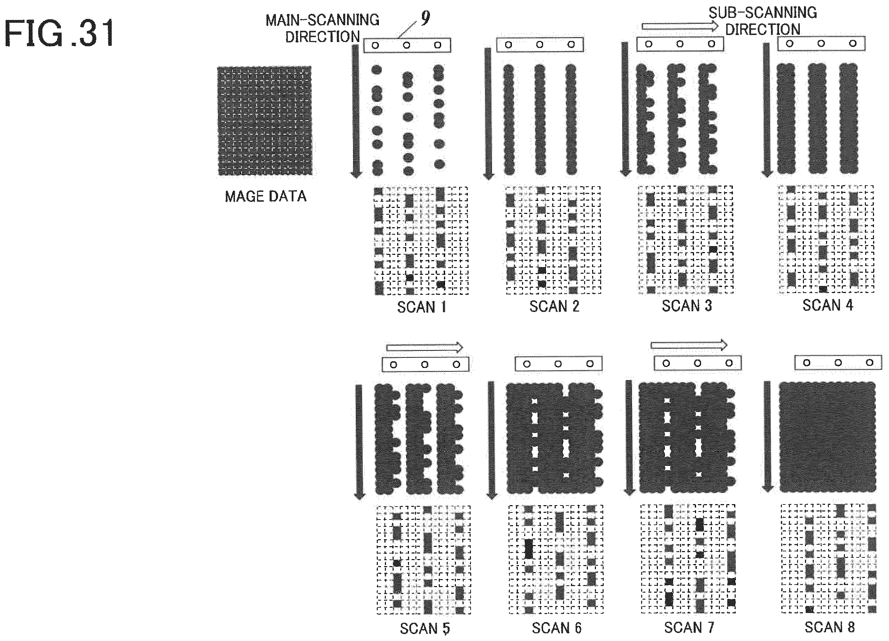

FIG. 31 illustrates a method of printing at resolution of 2400 dpi using a single inkjet print head with nozzle resolution of 600 dpi with random landing. In this method, printing is completed for each row in the main scanning direction.

In FIG. 31, printing of a row in the main scanning direction is completed in two successive scans, for example, Scan 1 and Scan 2. On the other hand, in the division printing, as illustrated in FIG. 29, it is completed in two scans of Scan 1 and Scan 5, which are not successive.

Thus, as the time required to complete printing a row in the main scanning direction is relatively long in the division printing, ink can be easily fixed, ink flow can be suppressed, and streaks and irregularities are less likely to occur.

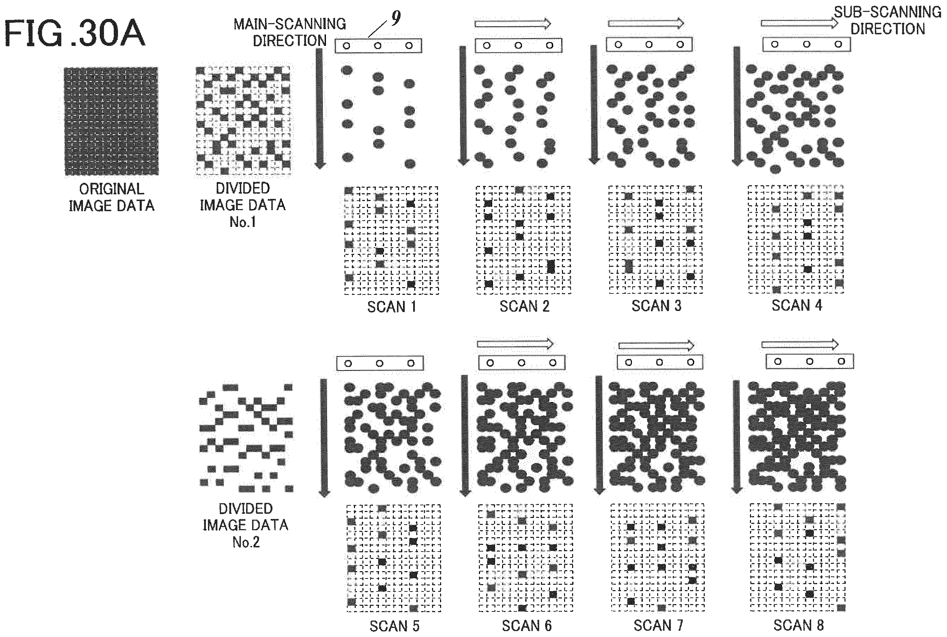

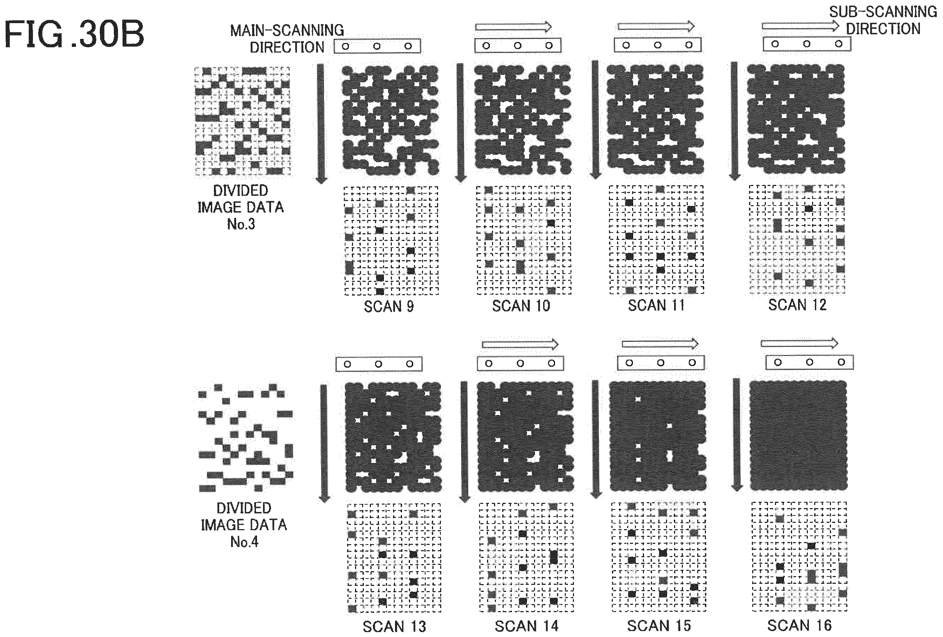

FIGs. 30A and B illustrate a method of dividing the original image data into four pieces and performing the division printing as in FIG. 29. In this case, printing of a row in the main scanning direction is completed in four non-successive scans of Scan 1, Scan 5, Scan 9, and Scan 13.

Thus, as the number of divisions of the original image data is increased, the number of scans until printing of a row in the main scanning direction is completed is increased. Therefore, the time required to complete printing is further elongated, so that streaks and irregularities are less likely to occur, and surface roughness can be reduced.

In addition, printing is also performed in the row direction before completion of printing the the column in the main scanning direction. Therefore, even when an ink having relatively high viscosity at the time of landing or an ink whose phase transition time is relatively short is used, the ink is less likely to be fixed in a linear shape in the main scan direction, and streaks and irregularities are less likely to occur. Furthermore, as the number of scans increases, misalignment of adjacent landings due to the interaction with the previously landed ink dots can be reduced. This improves pattern formability.

In the present embodiment, random landing means that the positions of dots on which the droplets land are controlled so as not to have a certain periodicity in the main scanning direction or sub scanning direction of the ink ejecting device, and not to be successive in the main scanning direction.

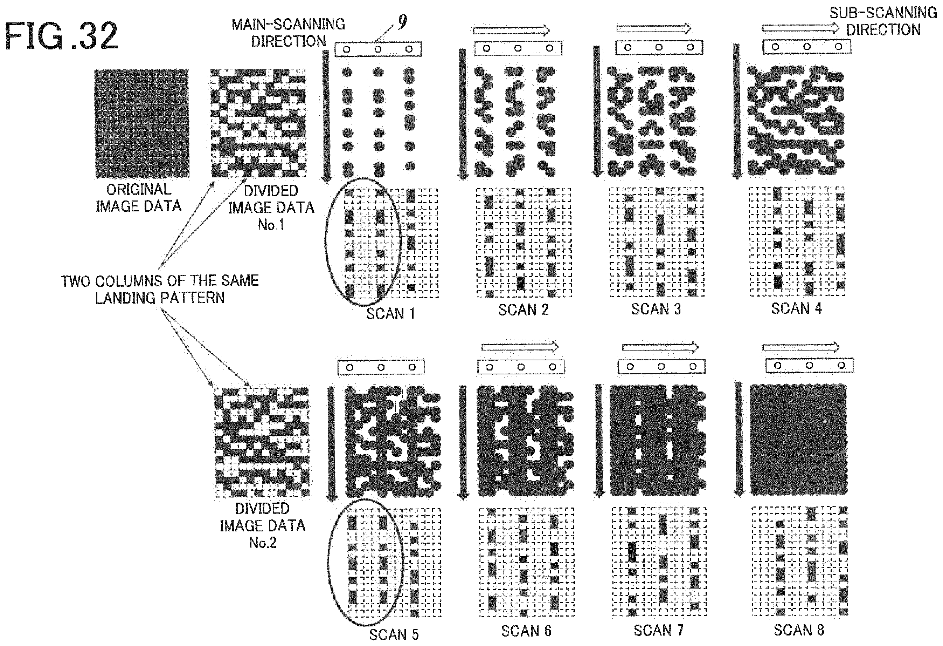

FIG. 32 illustrates a method of division printing as in FIG. 29. However, in Scan 1 and Scan 5, the positions of dots where the droplets ejected from the leftmost nozzle land are identical to the positions of dots where the droplets ejected from the middle nozzle land.

The streaks and irregularities that are the problems to be solved by the present invention are likely to occur when the dots where the droplets land are positioned periodically or regularly in the column direction in the main scanning direction. However, they are less likely to occur when the dots are positioned periodically or regularly in the row direction. Therefore, as illustrated in FIG. 32, the occurrence of streaks and irregularities can be sufficiently suppressed even when the positions of dots where the droplets ejected from different nozzles land are the same in a part of scans.

### 1.3.2 Bidirectional Printing

As an embodiment of the present invention, preferably, the ink ejecting device relatively moves back and forth in the main scanning direction and ejects droplets of ink in both the forward and backward passes.

In the present specification, a method that satisfies the above control conditions is referred to as "bidirectional printing."

In the following, an example of an embodiment of the method of pattern formation by the bidirectional printing will be described. However, the method is not limited to the embodiment and mode of the following example

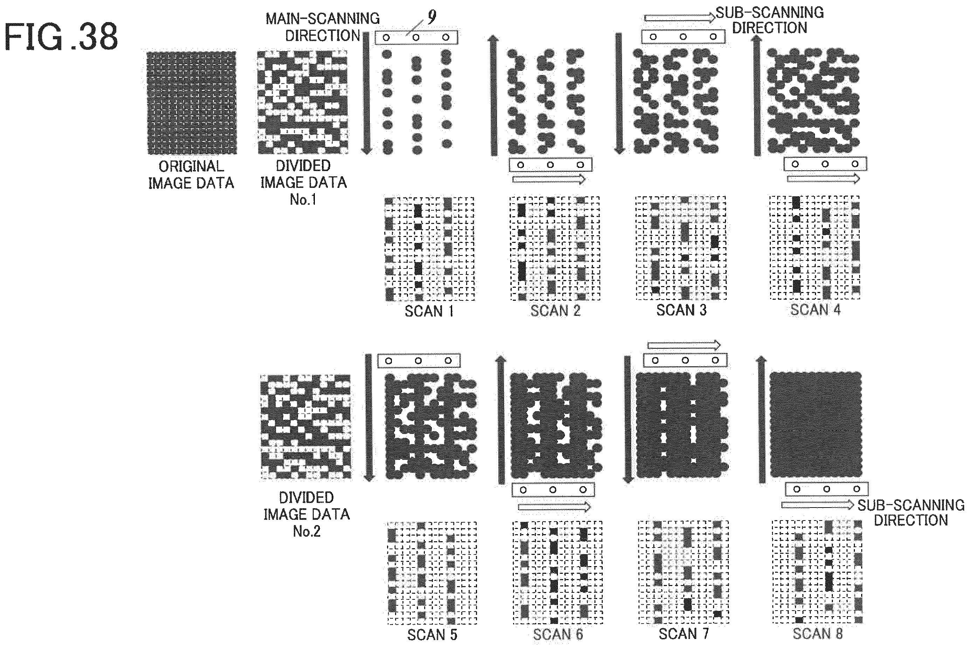

FIG. 38 illustrates a method of the bidirectional printing, in which the ink ejecting device relatively moves back and forth in the main scanning direction and ejects droplets of ink in both the forward and backward passes. Although division printing is performed in FIG. 38, it is not always necessary to perform division printing.

In Scan 1, the ink ejecting device moves relatively in the direction of the arrow (forward movement) while ejecting ink droplets. Next, in Scan 2, the ink ejecting device moves relatively in the direction of the arrow (backward movement) while ejecting a droplet of ink. The ink ejecting device relatively moves in the direction of the arrow (backward movement) such that a column of dots is formed on the right side of the column of dots formed in Scan 1. This is repeated until printing is completed with eight scans.

In the "relative movement" of the present embodiment, only one or both of the ink ejecting device and the board as the print media may move. The "relative movement" means that the ink ejecting device relatively moves in the positional relationship between the ink ejecting device and the board as the print media.

Therefore, in Scan 1 of FIG. 38, the ink ejecting device may be moved in the direction of the arrow while the board is fixed. Alternatively, the ink ejecting device may be fixed while the board is moved in the opposite direction of the arrow.

In the unidirectional printing illustrated in FIG. 29, although the ink ejecting device relatively moves back and forth in the main scanning direction, it ejects ink droplets only in the forward pass and only moves in the backward pass. Therefore, bidirectional printing leads to shorter printing time and higher productivity.

### 1.3.3 Backward and Forward Printing

As an embodiment of the present invention, preferably, the ink ejecting device relatively moves in a combination of a forward direction and an opposite direction with respect to the sub scanning direction.

In the present specification, a method that satisfies the above control conditions is referred to as "backward and forward printing."

In the following, an example of an embodiment of the method of pattern formation by the backward and forward printing will be described. However, the method is not limited to the embodiment and mode of the following example.

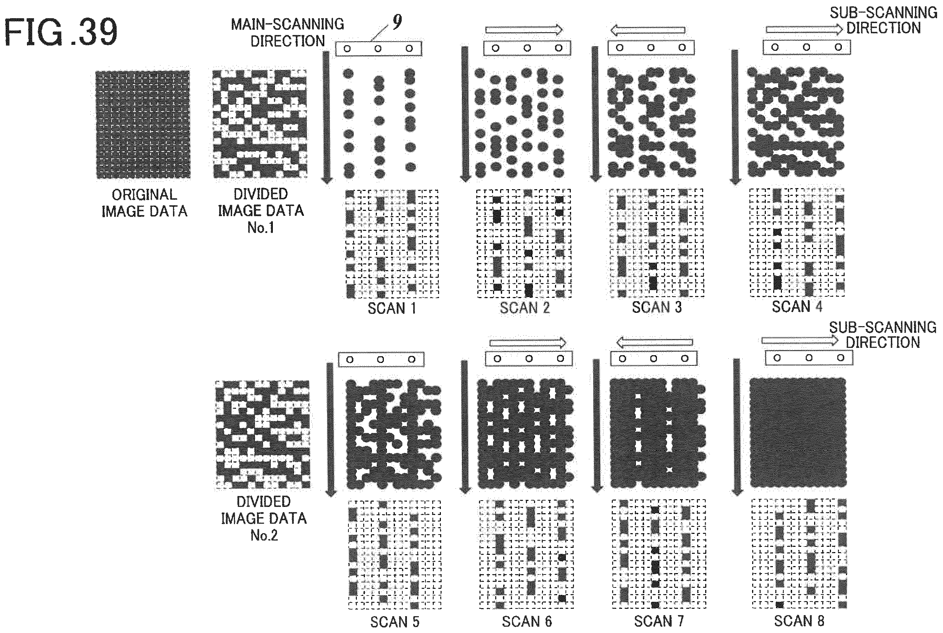

FIG. 39 illustrates a method of the backward and forward printing, in which the ink ejecting device relatively moves in the forward direction and in the opposite direction in combination with respect to the sub-scanning direction. Although division printing is performed in FIG. 39, it is not always necessary to perform division printing.

In Scan 1, the ink ejecting device moves relatively in the main scanning direction and ejects ink droplets. Next, in Scan 2, the ink ejecting device moves relatively in the direction of the arrow such that a column of dots is formed to the right of the column of dots formed in the Scan 1 with a space of one dot, further moves in the main scanning direction while ejecting ink droplets. Then, in Scan 3, the ink ejecting device moves relatively in the direction of the arrow such that a column of dots is formed between the column of dots formed in the Scan 1 and the column of dots formed in the Scan 2, further moves in the main scanning direction while ejecting ink droplets. This is repeated until printing is completed with eight scans.

In the forward direction printing illustrated in FIG. 29 where the relative movement direction of the ink ejecting device is only in one direction, in some cases, further dots are formed adjacent to the dots that have been formed. Then, dots are formed adjacent to dots where ink is not yet fixed, and streaks and irregularities are generated. On the other hand, in the backward and forward printing, dots are formed with a space between them and dots that have already been formed. Then, dots are formed adjacent to dots where ink has been fixed, and streaks and irregularities are less likely to be generated. Also, in the backward and forward printing, since dots are formed with a space between them and the already formed dots, misalignment of adjacent landings due to the interaction with the previously landed ink dots can be reduced. This improves pattern formability.

### 1.3.4 Application of Random Drop Multi-pass Method

As an embodiment of the present invention, preferably, the liquid amount of the ink used to form the coating layer of dots that constitute the pattern to be formed on the board is controlled so as to correspond to the shade or density of each pixel constituting the image data, so as not to have a certain periodicity with the neighboring dots, and so as not to be even as the entire coating layer of the pattern.

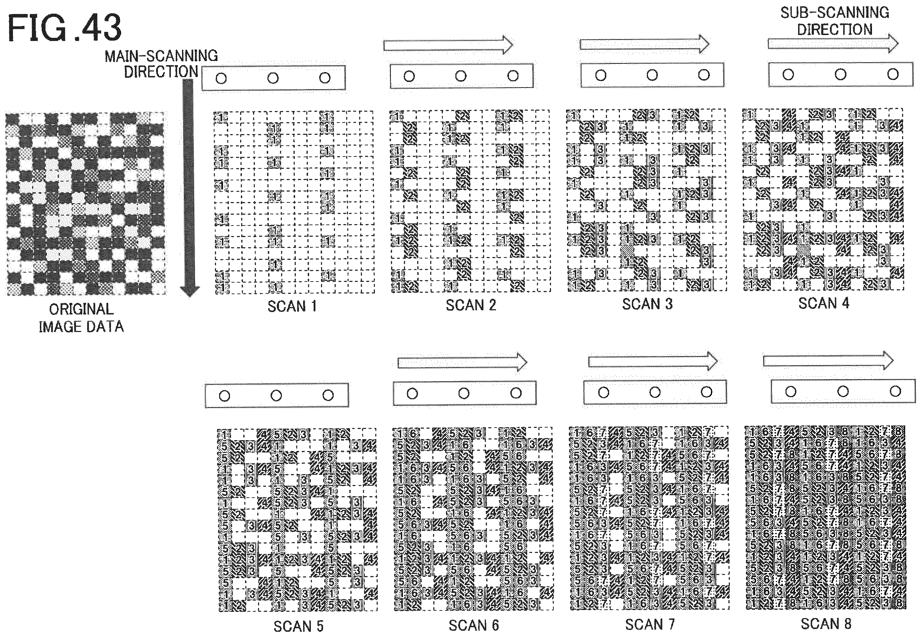

FIG. 43 illustrates a method of printing including random landing at a resolution of 2400 dpi using a single inkjet print head with a nozzle resolution of 600 dpi using multi-shaded image data.

Image data such as FIG. 31 may be used as the image data used in the random multi-pass method of the present invention, and respective dots may be formed with the same liquid amount. Alternatively, multi-shaded random image data as in FIG. 43 may be used to form dots with different liquid amounts, corresponding to the shade or density of respective pixels. In this way, when the random drop multi-pass method and the random multi-pass method are combined, the randomness of adjacent dots is further increased, and streaks and irregularities are less likely to occur.

As an embodiment of the present invention, depending on the shape of the pattern to be formed, preferably, control is performed such that the liquid amount of ink per dot (droplet) is substantially the same as for the dots (droplets) that form an inner edge of a patterned portion at the boundary between a patterned portion and a non-patterned portion formed on the board. Here, "the liquid amount is substantially the same" means that the difference in the liquid volume is within ±5%.

When the print medium is a board having a convex portion, such as a wiring board of an electronic device, it is also preferable to control the liquid amount of ink per dot (droplet) to be substantially the same as for the dots (droplets) that form an edge of the convex portion of the board.

Further, when the board has a convex portion, the liquid amount of ink per dot (droplet) as for the dots (droplets) that form an outer edge of a boundary between the inside and outside of the bottom of the convex portion is also preferably controlled to be more than the liquid amount of ink per dot (droplet) as for the dots (droplets) that form an edge of the convex portion.

In a preferred embodiment, when the board has a convex portion, the liquid amount of a dot (droplet) that forms the outer edge surface at the boundary between the inside and outside of the bottom surface of the convex portion is also controlled to vary continuously from the surface in contact with the convex portion to the surface in the outward direction.

As an embodiment of the present invention, depending on the properties of the ink to be used and the purpose of the pattern to be formed, preferably, the control is performed such that the average thickness of the coating layer of dots (droplets) that constitute the pattern is 15 µm or more from the viewpoint of the expression of the effect of the present invention.

Also, in an embodiment that is preferable from the same viewpoint as above, the liquid amount of ink that lands to form a coating layer of each dot (droplet) constituting the pattern is changed in multiple levels.

The various embodiments, conditions, and the like described above are specifically explained in the examples described later.

### 1.4 Ink

The ink used in the method of formation of the present invention is characterized in that the ratio η2/η1 of the viscosity η2 at a temperature upon landing to the viscosity η1 at a temperature upon ejection is 100 or more.

When η2/η1 is 100 or more, generation of bulges can be suppressed, and high resolution patterns can be formed. Also, η2/η1 is preferably 200 or more, and even more preferably 500 or more, because formation of a high resolution pattern on a board including different materials or uneven surfaces is improved.

The viscosity of the ink when it is ejected and when it lands is not particularly limited as long as it is within the range that satisfies the above ratio. However, the viscosity (η1) when the temperature at the time of ejection is 75°C, for example, is preferably in the range of 3 to 15 mPa·s from the viewpoint of ejection performance of the inkjet print head.

On the other hand, the viscosity (η2) is preferably from 1 × 10² to 1 × 10⁴ mPa·s when the temperature at the time of ink landing is set to room temperature (25°C).

When the viscosity (η2) is from 1 × 10² to 1 × 10⁴ mPa·s, ink is fixed on the board at the time of landing, and generation of bulges can be suppressed.

In the method of pattern formation of the present invention, particularly when such ink is used, it is possible to prevent the occurrence of insulation and conductive defects. The effect is particularly remarkable when the pattern is formed across different members or members having a convex shape.

In the present invention, the ink is preferably either of a hot-melt type ink, a gelled type ink, or a thixotropic type ink, described later.

### <Viscosity>

The "viscosity η2 at a temperature upon landing" is the reached viscosity of the ink before the substantial generation of ink flow due to wetting and spreading of the ink on the board (not due to the impact of the landing of the ink). Specifically, the viscosity η2 is reached within one second after the ink lands on the board. In the present invention, it is at the temperature of the board when the ink lands on the board.

On the other hand, the "viscosity η1 at a temperature upon ejection" is the temperature of the head when the ink is ejected from the head.

In the viscosity measurement, the ink is set in a stress-controlled rheometer (for example, Physica MCR300 manufactured by Anton Paar GmbH) that can control temperature, heated to 100°C, and cooled to 25°C at a cooling rate of 0.1°C/s. The viscosity measurement can be performed using a cone plate having a diameter of 75.033 mm and a cone angle of 1.017° (for example, CP75-1 manufactured by Anton Paar GmbH).

The temperature can be controlled using a temperature controlling device, for example, the Peltier element type temperature controller (TEK150P/MC1) that is an accessory to the PhysicaMCR300.

### <Method of Controlling Viscosity Ratio η2/η1>

The required viscosity ratio η2/η1 of the ink of the present invention can be satisfied as needed based on, for example, the composition of the ink, the setting of physical conditions such as temperature and humidity at the time of ink landing, and the like.

The viscosity of the ink can be preferably changed by any of the phase change mechanisms by hot melt, thixotropy, and gelling. The viscosity ratio η2/η1 required in the present invention can be satisfied based on the exhibited phase changing function of the ink from ejection to landing of the ink.

The term "hot melt" refers to melting by heating. The "phase change mechanism by hot melt" refers to the transition mechanism from a low viscosity state (at the time of ejection) due to heating (melting) to a high viscosity state (at the time of landing) due to cooling.

From the viewpoint of appropriate expression of the phase change mechanism by the hot melt, the temperature of the ink at the time of ejection is preferably different from that at the time of landing. For example, either one or both of heating of the ink at the time of ejection and cooling of the ink at the time of landing is preferably performed.

In the present invention, the temperature of ink at the time of ejection and at the time of landing different can be made different by using an appropriate temperature control means, such as a heater (heating means) that heats the ink filled in the inkjet print head, or a cooling means that cools the board.

The term "thixotropy" refers to a property like the average of a plastic solid such as a gel and a non-Newtonian liquid such as a sol, results in change in viscosity over time.

The phrase "phase change mechanism by thixotropy" refers to a phase change mechanism for transition of a state of the ink from a low viscosity state (at ejection) under the action of shear stress due to agitation or vibration to a high viscosity state (after landing) as the action of shear stress is reduced or stopped.

For example, the phase change mechanism by thixotropy can be expressed by appropriately using a shear stress imparting means that agitates or vibrates (microvibration) the ink filled in the inkjet print head.

The phrase "phase change mechanism by gelling" refers to a phase change mechanism for transition of a state of the ink from a low viscosity state (at ejection) due to the independent mobility of the solute to a high viscosity state (after landing) due to a structure formed the solute that has lost its independent mobility and aggregated due to an interaction such as polymer networks formed by chemical or physical aggregation, aggregated structures of fine particles, and the like. In this case, a gelling agent such as an oil gelling agent (details are described later) is preferably included in the ink.

From the viewpoint of appropriate expression of the phase change mechanism by gelling, the temperature of the ink at the time of ejection is preferably different from that at the time of landing. For example, in a preferred method, the ink is heated above the sol-gel phase transition temperature (gelling temperature) at the time of ejection to form a sol, and the ink is cooled below the sol-gel phase transition temperature (gelling temperature) at the time of landing to form a gel.

### <Thermosetting Inkjet Ink>

The ink used in the present invention is preferably a thermosetting inkjet ink that contains a compound having a thermosetting functional group and a gelling agent and undergoes a sol-gel phase transition depending on temperature. Even more preferably, the thermosetting inkjet ink contains a compound having a photopolymerizable functional group and a photopolymerization initiator.

### <<Thermosetting Functional Group>>

The thermosetting functional group is preferably at least one selected from the group consisting of a hydroxy group, a carboxy group, an isocyanate group, an epoxy group, a (meth)acrylic group, a maleimide group, a mercapto group, and an alkoxy group, from the viewpoint of thermosetting properties.

### <<Gelling Agent>>

The gelling agent is preferably kept in a uniformly dispersed state in the light- and heat-cured layer, and this prevents penetration of water into the cured layer.

Such a gelling agent is preferably at least one of the compounds represented by the following general formula (G1) or (G2) so as to be dispersed in the cured layer without interfering with the curing properties of the ink. Furthermore, the gelling agent is preferred in inkjet printing because of its good pinning property, drawing with both fine lines and layer thickness, and excellent fine line reproducibility.

General formula (G1): R₁-CO-R₂

General formula (G2): R₃-COO-R₄

[In the formula, R₁ to R₄ each independently represent an alkyl chain that has a linear portion having a linear portion with 12 or more carbon atoms and that may have a branch.]

A ketone wax represented by the general formula (G1) or an ester wax represented by the general formula (G2) has 12 or more carbon atoms in the linear or branched hydrocarbon group (alkyl chain), which increase the crystallinity of the gelling agent and improve water resistance of the gelling agent. In addition, more sufficient space is generated in the following card house structure. Therefore, ink media such as a solvent, a photopolymerizable compound, and the like are more easily encapsulated in the above space, resulting in a higher ink pinning property.

The number of carbon atoms in the linear or branched-chain hydrocarbon group (alkyl chain) is preferably 26 or less. When the number of carbon atoms is 26 or less, the melting point of the gelling agent is not excessively high, and the ink does not need to be excessively heated at the time of ejection.

From the above viewpoint, either R₁ and R₂ or R₃ and R₄ are particularly preferably linear hydrocarbon groups having 12 to 23 carbon atoms. From the viewpoint of raising the gelling temperature of the ink and causing the ink to become a gel more rapidly after landing, either of R₁ or R₂ or either of R₃ or R₄ is preferably a saturated hydrocarbon group having 12 to 23 carbon atoms.

From the above viewpoint, both R₁ and R₂ or both R₃ and R₄ are more preferably saturated hydrocarbon groups having 11 to 23 carbon atoms.

The content of the gelling agent is preferably within the range of 0.5 to 5.0% by mass of the total mass of the ink. By setting the content of the gelling agent within the above range, the gelling agent has good solubility to the solvent component and good pining effect, and also improves water resistance in the cured layer. From the above viewpoint, the content of the gelling agent in the inkjet ink is more preferably within the range of 0.5 to 2.5% by mass.

From the following viewpoint, the gelling agent is preferably crystallized in the ink at a temperature below the gelatinization temperature of the ink. The gelling temperature refers to the temperature at which the viscosity of the ink suddenly changes due to the phase transition of the gelling agent from sol to gel upon cooling the ink that has been made into sol or liquid by heating. Specifically, the ink that has been made into sol or liquid is cooled while its viscosity is measured with a viscoelasticity measuring device (for example, MCR300, manufactured by Physica), and the temperature at which the viscosity suddenly changes can be defined as the gelling temperature of the ink.

### <<Compound having Photopolymerizable Functional Group>>

A compound having a photopolymerizable functional group (also referred to as a photopolymerizable compound) is any compound that has a function of curing the ink by polymerizing or cross-linking in response to a polymerization or cross-linking reaction when irradiated with active light rays. Examples of the photopolymerizable compound include radical polymerizable compounds and cationic polymerizable compounds. The photopolymerizable compound may be a monomer, a polymerizable oligomer, a prepolymer, or a mixture thereof. The inkjet ink may contain only one photopolymerizable compound or two or more photopolymerizable compounds.

Radical polymerizable compounds are preferably unsaturated carboxylic acid ester compounds, and are more preferably (meth)acrylates. Such compounds include the above-mentioned compounds having a (meth)acryl group.

Cationic polymerizable compounds can be epoxy compounds, vinylether compounds, and oxetane compounds. The inkjet ink may contain only one cationic polymerizable compound or two or more cationic polymerizable compounds.

### <<Photopolymerization Initiator>>

The photopolymerization initiator is preferably a photo-radical initiator when the photopolymerizable compound is a radical polymerizable compound, and is preferably a photoacid generator when the photopolymerizable compound is a cationic polymerizable compound.

The inkjet ink may contain only one photopolymerization initiator or two or more photopolymerization initiator. The photoinitiator may be a combination of both a photo-radical initiator and a photoacid generator. The photo-radical initiator includes a cleavage type radical initiator and a hydrogen-drawing type radical initiator.

### <<Colorant>>

The ink used in the present invention may further include a colorant as needed. The colorant may be a dye or a pigment, and is preferably a pigment due to its good dispersibility with the constituents of the ink and its excellent weather resistance.

Dispersion of pigments is preferably carried out such that the volume average diameter of pigment particles is preferably in the range of 0.08 to 0.5 µm, the maximum particle diameter is preferably in the range of 0.3 to 10 µm, and more preferably in the range of 0.3 to 3 µm. Dispersion of the pigment is adjusted by selection of pigment, dispersant, and dispersion medium, dispersion conditions, and filtration conditions.

A dispersant and a dispersing aid may be further included to enhance the dispersibility of the pigment. The total amount of the dispersant and the dispersing aid is preferably in the range of 1 to 50% by mass with respect to the pigment.

The ink used in the present invention may further include a dispersion medium for the dispersion of the pigment, if necessary. The ink may include a solvent as the dispersion medium. In order to reduce residual solvent in the formed printed material, the aforementioned photopolymerizable compound (in particular, a monomer having low viscosity) is preferably used as a dispersion medium.

The dye to be used is, for example, an oil-soluble dye.

One or more kinds of colorants may be included in the ink and toned to the desired color. The content of the colorant is preferably in the range of 0.1 to 20% by mass of the total amount of the ink, and more preferably in the range of 0.4 to 10% by mass.

### <<Other Components>>

The ink used in the present invention may further include other components such as a polymerization inhibitor, a surfactant, a curing accelerator, a coupling agent, an ion scavenger, and the like, as long as the effect of the present invention is achieved. The inkjet ink may contain only one of such components or two or more of such components. From the viewpoint of curing properties, a solvent is not preferably included, but can be added to adjust the ink viscosity.

### <<Physical Properties>>

The viscosity of the ink used in the present invention at 25°C is preferably in the range of 1 to 1 × 10⁴ Pa·s for sufficient gelling of the ink when the ink lands and is cooled to room temperature, and for good pinning properties. From the viewpoint of enhancing ejection performance from the inkjet print head, the viscosity of the ink at 80°C is preferably in the range of 3 to 20 mPa·s, and more preferably in the range of 7 to 9 mPa·s.

The ink used in the present invention preferably has a phase transition point in the range of 40°C or more to less than 100°C. When the phase transition point is 40°C or more, the ink gels quickly after landing on the print medium, resulting in higher pinning properties. When the phase transition point is less than 100°C, ink handling properties are improved and dispensing stability is enhanced. From the viewpoint of enabling ink ejection at lower temperature and reducing the load on the image forming device, the phase transition point of the ink is preferably in the range of 40 to 60°C.

From the viewpoint of further improving ejection properties from the inkjet print head, the average dispersion particle diameter of the pigment particles of the present invention is preferably in the range of 50 to 150 nm, and the maximum particle diameter is preferably in the range of 300 to 1000 nm. Even more preferred average dispersion particle diameters are in the range of 80 to 130 nm. The average dispersion particle diameter of the pigment particles in the present invention means the value obtained by the dynamic light scattering method using the Datasizer Nano ZSP (manufactured by Malvern). The ink including the colorant has a high concentration and does not transmit light using this measurement device. Therefore, measurement is performed after diluting the ink by a factor of 200. The temperature for measurement is room temperature (25°C).

### <<Formation of Solder Resist Pattern»

The ink used in the present invention is preferably a solder resist ink for forming solder resist patterns used in printed circuit boards. When a solder resist pattern is formed using this ink, moisture penetration into the solder resist pattern can be prevented. As a result, adhesiveness at the interface between the copper foil and the solder resist pattern on the printed circuit board becomes good, and copper migration is prevented, thereby suppressing the degradation of insulation properties.

The method of forming a solder resist pattern using the ink used in the present invention preferably includes the following steps: (1) ejecting the ink from the nozzle of the inkjet print head to make it land on the printed circuit board on which the circuit is formed, and (3) heating the ink for final curing.

When the ink used in the present invention includes a compound having a photopolymerizable functional group and a photopolymerization initiator, irradiating the ink that has landed with active light rays and temporarily curing the ink is preferably included between the above steps (1) and (3).

### Step of (1):

In the step (1), droplets of the ink of the present invention are ejected from the inkjet print head and land on the printed circuit board as the print media at positions corresponding to the solder resist pattern to be formed. Patterning is thus performed. The ejection method from the inkjet print head can be either an on-demand method or a continuous method.

When ink droplets in a heated state are ejected from the inkjet print head, ejection stability can be enhanced. The temperature of the ink when it is ejected is preferably in the range of 40 to 100°C. For further enhancement of ejection stability, the temperature is more preferably in the range of 40 to 90°C. In particular, ejection is preferably performed at an ink temperature at which the viscosity of the ink is in the range of 7 to 15 mPa·s, more preferably in the range of 8 to 13 mPa·s.

In order to achieve enhanced ejection properties from the inkjet print head, the sol-gel phase transition type ink filled in the inkjet print head is preferably set at a temperature of (gelling temperature + 10) °C to (gelling temperature + 30) °C of the ink. When the temperature of the ink in the inkjet print head is less than (gelling temperature + 10) °C, the ink is likely to gel in the inkjet print head or on the nozzle surface, resulting in poor ink ejection properties. On the other hand, when the temperature of the ink in the inkjet print head exceeds (gelling temperature + 30) °C, the ink becomes too hot and the ink components may be deteriorated.

The method of heating the ink is not particularly limited. For example, the ink can be heated by heating at least one of the ink supply system, such as an ink tank constituting a head carriage, a supply pipe, and a front chamber ink tank immediately before the head, a pipe with a filter, and a piezo head, using a panel heater, a ribbon heater, or a warm water. The volume of the droplet of ink at the time of ejection is preferably in the range of 2 to 20 pL from the viewpoint of printing speed and image quality.

The printed circuit board is not particularly limited, and preferred examples thereof include copper-clad laminates of all grades (FR-4 and the like) employing materials such as copper-clad laminates for high frequency circuit in which paper phenol, paper epoxy, glass fabric epoxy, glass polyimide, glass fabric/nonwoven fabric epoxy, glass fabric/paper epoxy, synthetic fiber epoxy, and fluorine/polyethylene/PPO/cyanate ester are used. The preferred examples also include polyimide films, PET films, glass boards, ceramic boards, wafer plates, stainless steel plates, and the like.

### Step of (2):

In the step (2), the ink that has landed in the step (1) is irradiated with active light rays and temporarily cured. Examples of the active light rays can be selected from electron beams, ultraviolet rays, alpha rays, gamma rays, and X-rays, and preferably ultraviolet rays. Irradiation of ultraviolet rays can be performed using a watercooled LED manufactured by Phoseon Technology, for example, at a wavelength of 395 nm. With LED as the light source, it is possible to suppress ink curing defects caused by melting of the ink due to the radiation heat from the light source.

The ultraviolet rays irradiation is performed such that the ultraviolet rays with wavelengths in the range of 370 to 410 nm have a peak irradiance on the surface of the solder resist pattern preferably in the range of 0.5 to 10 W/cm², more preferably in the range of 1 to 5 W/cm². From the viewpoint of suppressing irradiation of the ink with radiant heat, the light irradiation to the solder resist pattern is preferably less than 500 mJ/cm². Irradiation of active light rays is preferably performed between 0.001 and 300 seconds after landing of ink, and more preferably between 0.001 and 60 seconds for the formation of a highly precise solder resist pattern.

### Step of (3):

In the step (3), after the temporary curing in the step (2), the ink is further heated for final curing. The heating method preferably involves, for example, placement in an oven that is set at a temperature in the range of 110 to 180°C for 10 to 60 minutes.

The ink used in the present invention can be used as a solder resist patterning ink as described above, as well as an adhesive, encapsulant, and circuit protection agent for electronic components.

In the present invention, portions where the solder resist pattern is provided are not particularly limited. However, as mentioned above, the effect of the present invention is particularly significant when the solder resist pattern is formed over different members or on uneven members.

### 2 Inkjet Printing Device

In the following, the functions of the basic components of an inkjet printing device (also referred to as an "inkjet recording device") of a multi-pass method that can be used in the present invention will be described.

FIG. 8 is a schematic diagram illustrating an inkjet printing device 1 of the multi-pass system; A front view, B top view.

This inkjet printing device 1 is basically a printing device that ejects ink in a multi-pass method, in which the head 3 moves back and forth to perform overlapping printing. This inkjet printing system 1 includes a carriage 2 on which the head is mounted, an X-direction linear stage 4 that moves the carriage 2, a table 5 on which the board is placed, and a Y-direction linear stage 6 that moves the table 5.

The inkjet printing system 1 performs printing while the head 3 moves in the X direction and the table 5 on which the board is placed moves in the Y direction.

Although not shown in the drawing, the inkjet printing device 1 includes a device that controls ejection of ink from the head 3 and a computer that controls the XY stages. The computer that controls the XY stages controls the operation of the XY stages based on the image data.

The above computer includes a CPU (Central Processing Unit), ROM (Read Only Memory), RAM (Random Access Memory), and other components.

In the printing in the X-direction, the carriage 2 with the head 3 attached is mounted on the linear stage 4 in the X direction and is moved to the desired position by the computer controlling the XY stages.

In the printing in the Y-direction, the table 5 on which the board is placed moves in the Y direction, and ink is ejected from the head when the board passes under the head. The device that controls ink ejection from the head 3 is coupled with an encoder placed on the linear stage 6 in the Y direction, and ink is ejected at the resolution of the image data in response to the encoder signal.

When printing with a resolution higher than the resolution of the head in the X direction, the head is moved multiple times in the X direction for printing.

For example, when printing at a resolution of 2400 dpi with one inkjet print head with a resolution of 600 dpi, the head moves 10.6 µm in the X direction (corresponding to one pixel of 2400 dpi) after printing in the first scan in the Y direction, and printing in the second scan in the Y direction is performed. The head further moves 10.6 µm in the X direction, and printing in the third scan in the Y direction is performed. After that, the head moves 10.6 µm in the X direction, and printing in the fourth scan in the Y direction is performed, and the printing is completed.

In the above, printing is done in only one conveying direction, but printing can also be done in both directions (referred to as bidirectional printing).

When the printing area is larger than the head width, printing is performed with the head moved in the X direction by the head width.

Further study by the inventor has revealed the following. The main scanning direction and sub scanning direction of the ink ejecting device need not be perpendicular or parallel to the nozzle row. Streaks and irregularities are less likely to occur whether only one of the ink ejecting device and the board as the print media moves to form a pattern or both of them move to form a pattern.

In the following, inkjet printing devices of multi-pass method that is not described above but can be used in the present invention will be described.

The ink ejecting device (the same as the "head" above) has a plurality of nozzle holes where ink is ejected. The nozzle holes are preferably aligned in one column, but the nozzle column does not have to be perpendicular or parallel to the main scanning direction (same as the "Y direction" above) and the sub scanning direction (same as the "X direction" above) of the head, and may be aligned in any direction.

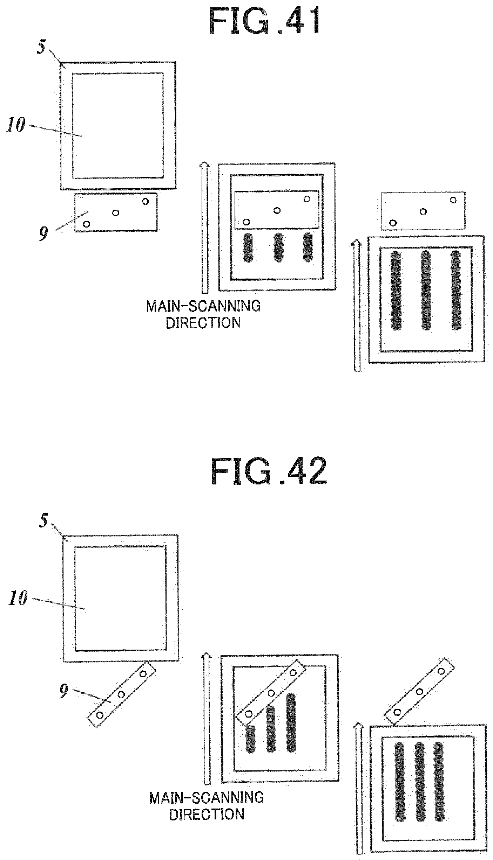

FIG. 41 illustrates the printing method when the direction of the nozzle column is not perpendicular to or parallel to either the X direction or the Y direction, but is at an angle. An inkjet printing device having a nozzle column at an angle can also be used in the method of pattern formation of the present invention.

FIG. 42 illustrates the printing method when the direction of the ink ejecting device is not perpendicular to or parallel to either the X direction or the Y direction, but is at an angle. When the angle between the ink ejecting device and the main scanning direction is changed appropriately, the space between dots to be formed can be changed. Therefore, the nozzle resolution can be increased without adding ink ejecting devices. Such inkjet printing devices can also be used for the method of pattern formation of the present invention.

In the above inkjet printing device 1, the head moves in the X direction and the board moves in the Y direction during printing. However, the method of pattern formation of the present invention can also be used in an inkjet printing device in which the head moves in the Y direction and the board moves in the X direction, in an inkjet printing device in which the board moves in both the X and Y directions, and in an inkjet printing device in which the head moves in both the X and Y directions.

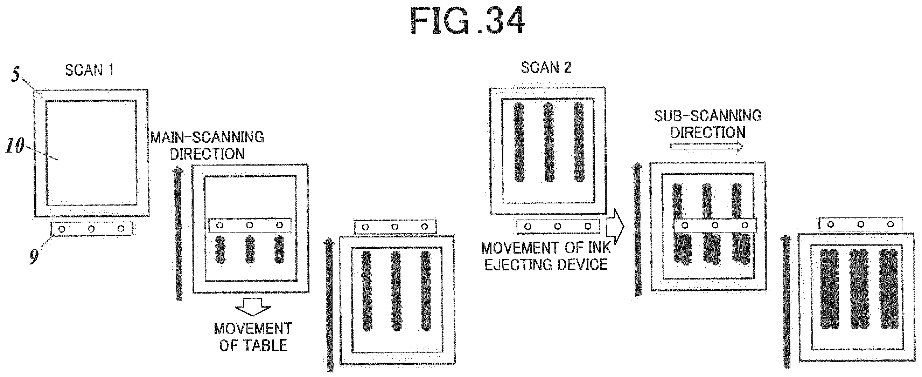

FIG. 34 illustrates the method of printing with the inkjet printing device 1 described above. In Scan 1, the head is fixed, and ink droplets are ejected from the head when the board moves in the arrow direction and passes under the head. This causes the head to relatively move in the main scanning direction in terms of the positional relationship between the board and the head. In printing at a higher resolution than that of the head, in Scan 2, the head moves in the arrow direction, the board moves again in the arrow direction, and the ink droplets are ejected. This is repeated until printing is completed.

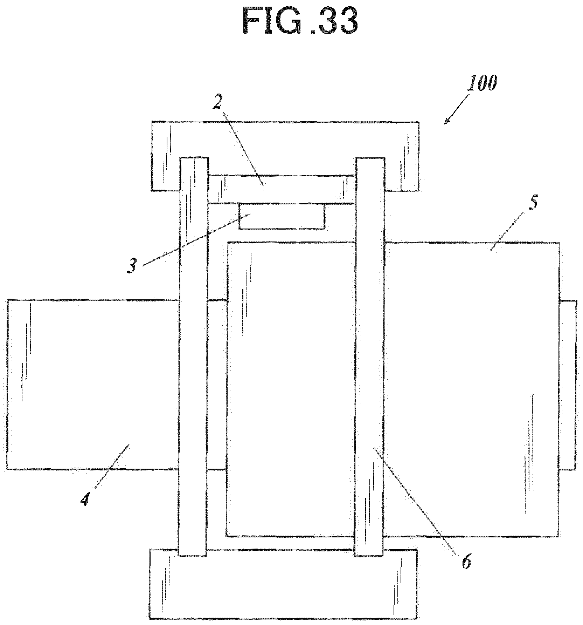

In the inkjet printing device 100 illustrated in FIG. 33, it is performed as the carriage 2 with the head 3 is mounted on the linear stage 6 in the Y direction and is moved to the desired position by the computer that controls the XY stages.

In the X-direction printing method, after printing in the main scanning direction in the Y-direction, the table 5 on which the board is placed moves in the X-direction, and the next printing in the main scanning direction in the Y-direction is performed.

Similar to the inkjet printing system 1, the device that controls ink ejection from the head 3 is coupled with an encoder placed on the linear stage 4 in the X direction, and ink is ejected at the resolution of the image data in response to the encoder signal.

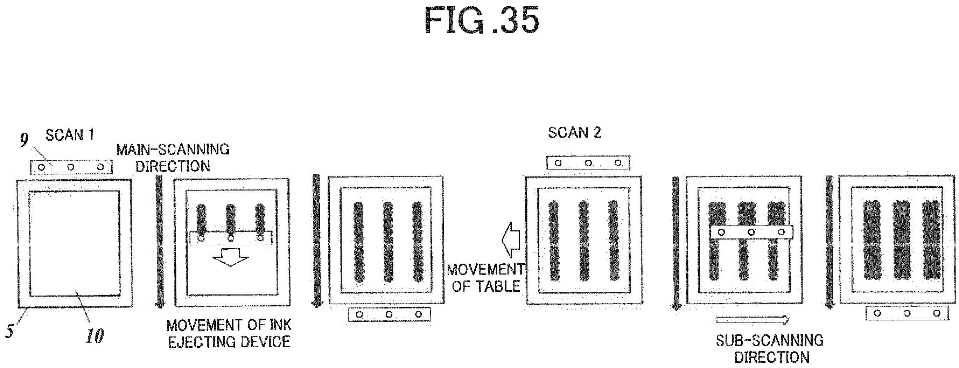

FIG. 35 illustrates the method of printing with the inkjet printing device 100. In Scan 1, the head moves on the fixed board in the main scanning direction and ejects ink droplets. Next, in Scan 2, the board moves in the arrow direction such that the head relatively moves in the sub scanning direction in terms of the positional relationship between the board and the head. Then, the ink ejecting device again moves on the fixed board in the main scanning direction to eject ink droplets. This is repeated until printing is completed.

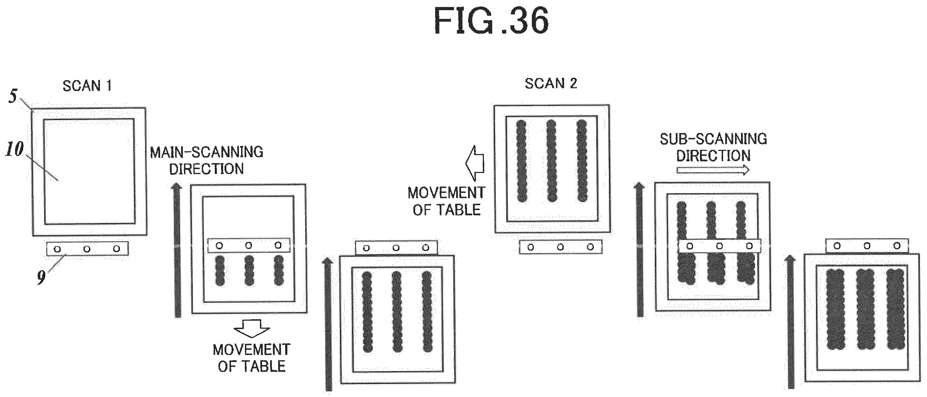

FIG. 36 illustrates the method of printing with an inkjet printing device in which the board moves in both the X and Y directions. In Scan 1, the head is fixed, and ink droplets are ejected from the head when the board moves in the arrow direction and passes under the head. This causes the head to relatively move in the main scanning direction in terms of the positional relationship between the board and the head. Next, in Scan 2, the board moves in the arrow direction such that the head relatively moves in the sub scanning direction in terms of the positional relationship between the board and the head. Then, the ink ejecting device again moves on the fixed board in the main scanning direction to eject ink droplets. This is repeated until printing is completed.

FIG. 36 illustrates the method of printing with an inkjet printing device in which the head moves in both the X and Y directions. In Scan 1, the head moves on the fixed board in the main scanning direction and ejects ink droplets. Next, in Scan 2, the head moves in the arrow direction, the board again moves in the arrow direction, and ink droplets are ejected. This is repeated until printing is completed.

Also, when multiple heads are attached to the carriage in a row, the number of scans can be reduced, and printing time can be shortened.

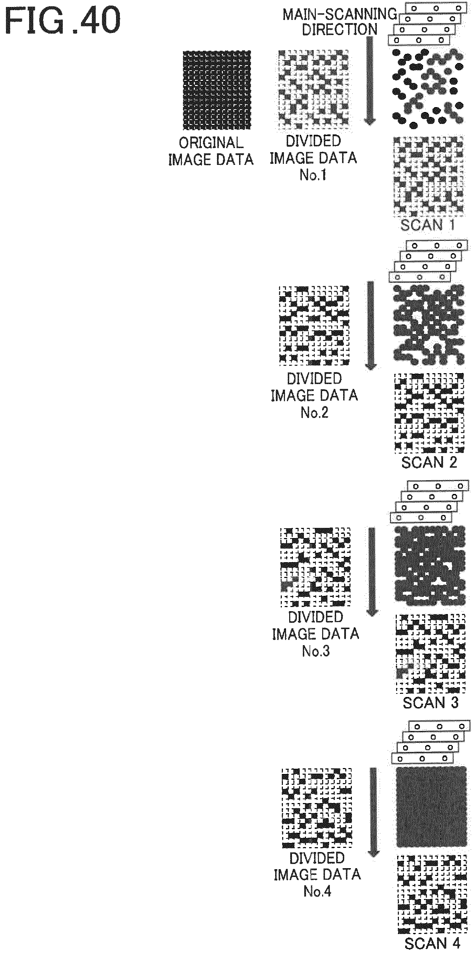

FIG. 40 illustrates a method of printing at a resolution of 2400 dpi using four inkjet print heads whose nozzle resolution is 600 dpi, using divisional printing. The four inkjet print heads are attached to the carriage displaced from each other so as to achieve a resolution 2400 dpi pitch.

As shown in FIG. 30A and B, when one inkjet print head with a nozzle resolution of 600 dpi is used in printing at a resolution of 2400 dpi using four pieces of division image data, sixteen scans are required. However, as shown in FIG. 40, when four inkjet print heads are attached displaced from each other, the process from Scan 1 to Scan 4 illustrated in FIG. 30A can be performed in a single scan. Therefore, printing can be completed in a total of four scans, thus printing time can be reduced.

In an example of a printing method with a random multi-drop method in the present invention, as described above, a multi-shaded random gray image is used to control the liquid amount corresponding to the shade or density of each pixel.

For example, a 30% gray image with 256 shades is processed with a noise filter using Adobe Photoshop, and random multi-shaded gray image data such as in FIG. 16 can be prepared. Based on this image data, the liquid amount can be distributed, for example, 7 pL for the black portions of 0 to 86 shades, 3.5 pL for the gray portions of 87 to 172 shades, and 0 pL for the white portions of 173 to 255 shades.

The formation of dots with different liquid amounts corresponding to respective pixels can be achieved by changing the ejection waveform when ink is ejected from the nozzle or by forming multiple dots for a single pixel.

For example, when the liquid amounts are distributed as described above, dots of different liquid volumes can be formed using an inkjet print head with a liquid volume of 3.5 pL, under the definition that two droplets are ejected for the black portion of 0 to 86 shades, one droplet is ejected for the gray portion of 87 to 172 shades, and no droplet is ejected for the white portion of 173 to 255 shades.

Methods of printing with the random multi-pass method in the present invention include a printing method in which an original image is divided into multiple random, non-overlapping images, a method in which landing is randomized using an inkjet ejection control system with a function such as a random number, and the like.

Division image data can be prepared by the following methods. It can be prepared using image processing software such as Photoshop 2020 by Adobe. For example, a gray image is processed into a monochrome 2-shade image using the error diffusion method or the like with Photoshop, and a random black-and-white image is prepared. Next, the color tones of the images are inverted to produce images with black and white inverted.

### [Examples]

Hereinafter, the present invention will be specifically described with examples, but the present invention is not limited to these examples. In the examples, when "part" or "%" is used, it means " part by mass" or "% by mass," respectively, unless otherwise noted.

### <<Example 1>>

### [Preparation of Ink]

### <Preparation of Pigment Dispersion Liquid>

The dispersant and dispersion medium listed below were put in a stainless steel beaker, heated and stirred to dissolve on a hot plate at 65°C for one hour, cooled to room temperature, mixed with the pigment, and placed in a glass bottle with 200 g of 0.5 mm diameter zirconia beads, and the bottle was sealed tightly. After dispersion process with a paint shaker until a desired particle diameter was obtained, the zirconia beads were removed.

### (Yellow Pigment Dispersion)

| | |
|---|---|
| Dispersant 1: EFKA 7701 (manufactured by BASF) | 5.6 parts by mass |
| Dispersant 2: Solsperse 22000 (manufactured by Nihon Lubrizol Co., Ltd.) | 0.4 parts by mass |
| Dispersion Medium: Dipropylene glycol diacrylate (containing 0.2% UV-10) | 80.6 parts by mass |
| Pigment: PY185 (manufactured by BASF, Paliotol Yellow D1155) | 13.4 parts by mass |

### (Cian Pigment Dispersion)

| | |
|---|---|
| Dispersant: EFKA 7701 (manufactured by BASF) | 7 parts by mass |
| Dispersion Medium: Dipropylene glycol diacrylate (containing 0.2% UV-10) | 70 parts by mass |
| Pigment: PB15:4 (manufactured by Dainichiseika, Chromo-fine blue 6332JC) | 23 parts by mass |

After mixing the prepared dispersions in the following combination, filtration was performed using a Teflon (registered trademark, manufactured by ADVATEC) 3 µm membrane filter, and the ink was prepared. The viscosity (η1) at 75°C, the temperature at the time of ink ejection, was 10 mPa·s, and the viscosity (η2) at room temperature (25°C), the temperature at the time of landing, was 1 × 10⁴ mPa·s. In other words, the viscosity ratio η2/η1 was 1000. The same ink was used in the following examples and comparative examples.

| | |
|---|---|
| Yellow pigment dispersion | 3 parts by mass |
| Cyan pigment dispersion | 1 part by mass |
| Distearyl ketone | 1.1 parts by mass |
| Behenyl behenate | 1.2 parts by mass |
| Epoxy ester (M-600A: manufactured by Kyoei Chemical) | 30 parts by mass |
| TrixeneBI7961 (manufactured by LANXESS) | 10 parts by mass |
| Urethane acrylate (AH-600: manufactured by Kyoei Chemical) | 10 parts by mass |
| M222 (manufactured by Miwon) | 27.7 parts by mass |
| EM2382 (manufactured by Choko Chemical) | 10 parts by mass |
| Photoinitiator: Diphenyl (2,4,6-trimethylbenzoyl) phosphine oxide (TPO) | 3 parts by mass |
| Photoinitiator Auxiliary Agent: 2-isopropylthioxanthone (ITX) | 3 parts by mass |

### [Printing of Pattern]

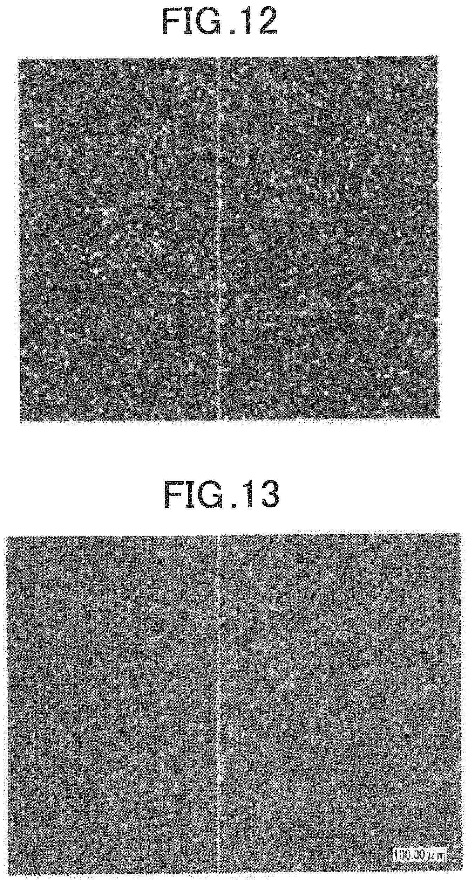

Using a linear XY stage with one inkjet print head (KM1800iSHC-C: manufactured by Konica Minolta, resolution 600 dpi) and a control system (IJCS-1: manufactured by Konica Minolta), a printing pattern was printed on an optical PET film as a board under the following conditions. A printed material 1 was produced through exposure to UV-LED light at a wavelength of 395 nm and irradiation energy of 500 mJ/cm² and a curing process. An optical microscope photograph of the printed material 1 at a magnification of 100 is shown in FIG. 13.
Printing Pattern: A hollow circle with a diameter of 100 to 1000 µm is placed on a square solid portion of 70 mm × 70 mm
Image data of the solid portion: see FIG. 12 (50% gray in 256 shades converted to random multi-shaded gray using noise filtering in image processing software Photoshop 2020 by Adobe)
Resolution: 2400 dpi × 3000 dpi (conveying direction)
Number of passes: 4 (600 dpi × 4)
Moving distance of head nozzle in column direction between passes: 10.6 µm
Printing method: block

| | |
|---|---|
| Liquid volume distribution: | 0 to 86 shades 3.5 pL |
| | 87 to 255 shades 0 pL (no droplet application) |

Head temperature (temperature upon ink ejection): 75°C
Board temperature (temperature upon ink landing): Room temperature (25°C)

### <<Example 2>>

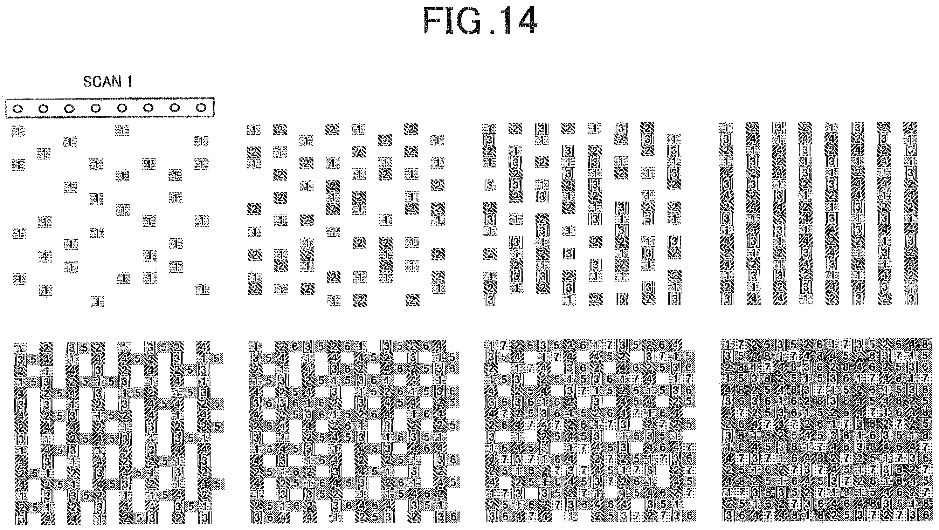

Using a linear XY stage with one inkjet print head (KM1800iSHC-C: manufactured by Konica Minolta, resolution 600 dpi) and a control system (IJCS-1: manufactured by Konica Minolta), a printing pattern was printed on an optical PET film as a board under the following conditions in the random multi-pass method shown in an example of the present embodiment, in which the head with a resolution of 600 dpi is moved 8 times in the conveying direction and once in the head nozzle column direction in numerical order as shown in FIG. 14. A printed material 2 was produced through exposure to UV-LED light at a wavelength of 395 nm and irradiation energy of 500 mJ/cm² and a curing process.
Printing Pattern: A hollow circle with a diameter of 100 to 1000 µm is placed on a square of 70 mm × 70 mm
Image data of the solid portion: see FIG. 15
Resolution: 1200 dpi × 1200 dpi (conveying direction)
Number of passes: 8 (600 dpi × 4 × 2)
Moving distance of head nozzle in column direction between passes: 21.2 µm
Printing method: Random passes
Liquid volume distribution:10.5 pL on entire surface
Head temperature (temperature upon ink ejection): 75°C
Board temperature (temperature upon ink landing): Room temperature (25°C)

### <<Example 3>>

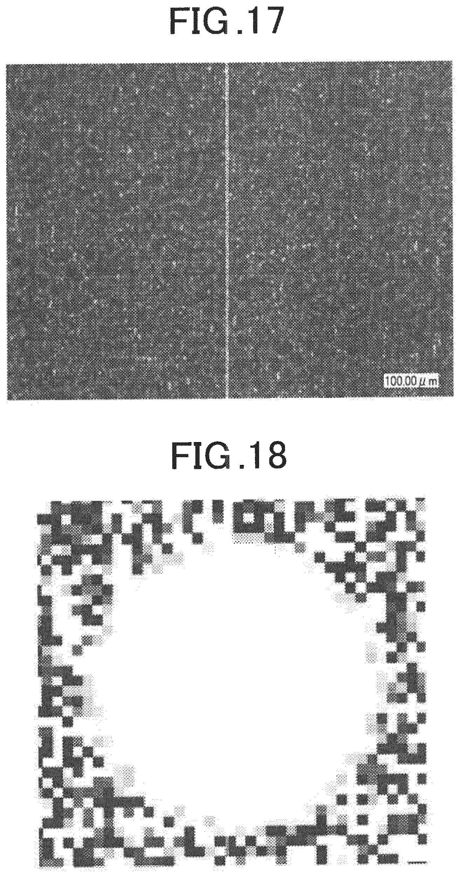

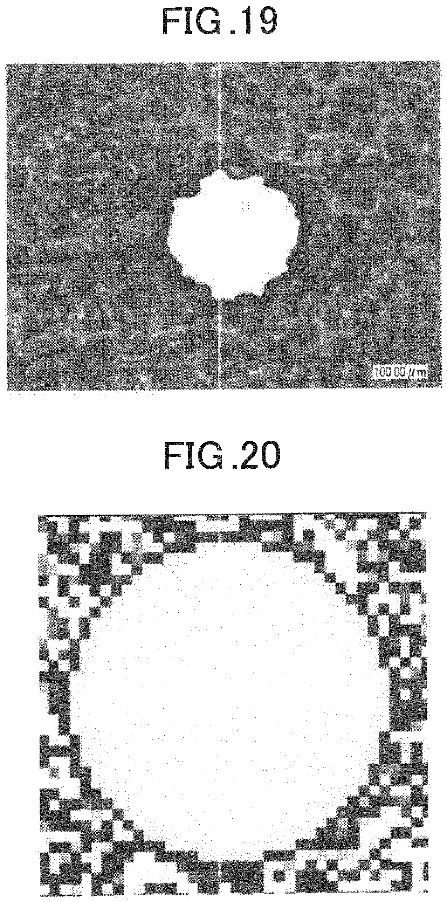

A printed material 3 was prepared in the same way as in Example 1, except that the printing conditions were changed to the following conditions. An optical microscope photograph of the printed material 3 at a magnification of 100 is shown in FIG. 17. An optical microscope photograph of the hollow circle with a diameter of 500 µm at a magnification of 100 is shown in FIG. 19.
Printing Pattern: A hollow circle with a diameter of 100 to 1000 µm is placed on a square of 70 mm × 70 mm
Image data of the hollow circle: see FIG. 18 (hollow circle without edge)
Image data of the solid portion: see FIG. 16 (30% gray in 256 shades converted to random multi-shaded gray using noise filtering in image processing software Photoshop 2020 by Adobe)
Resolution: 2400 dpi × 2400 dpi (conveying direction)
Number of passes: 4 (600 dpi × 4)
Moving distance of head nozzle in column direction between passes: 10.6 µm
Printing method: block

| | |
|---|---|
| Liquid volume distribution: | 0 to 86 shades 7 pL |
| | 87 to 172 shades 3.5 pL |
| | 173 to 255 shades 0 pL (no droplet application) |

### <<Example 4>>

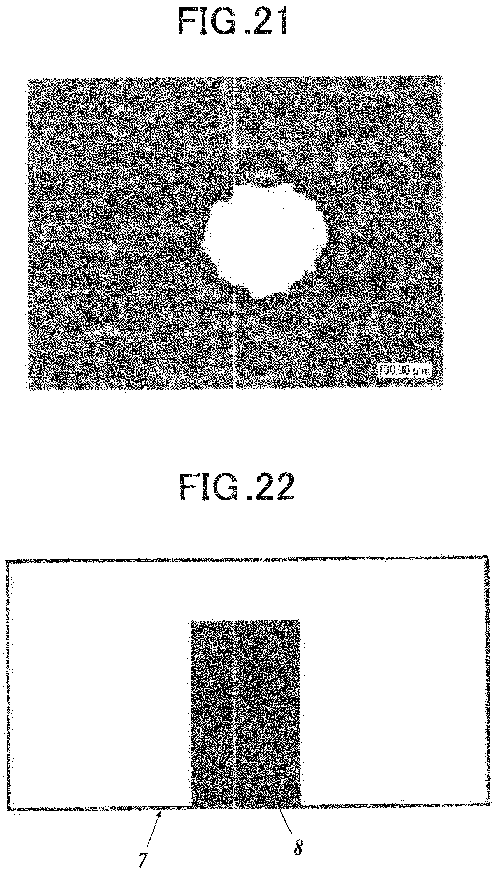

A printed material 4 was prepared in the same way as in Example 3, except that the printing conditions were changed to the following conditions. An optical microscope photograph of the hollow circle with a diameter of 500 µm of the printed material 4 at a magnification of 100 is shown in FIG. 21.

Image data of the hollow circle portion: FIG. 20 (The edge of the hollow circle was uniformly gray at shade 155 so that the liquid volume per pixel was the same.

### <<Example 5>>

A printed material 5 was prepared in the same way as in Example 3, except that the board was changed to a printed wiring board of glass epoxy board with Cu wiring pattern having Cu thickness of 15 µm and L/S (line/space) is 100 µm/100 µm.

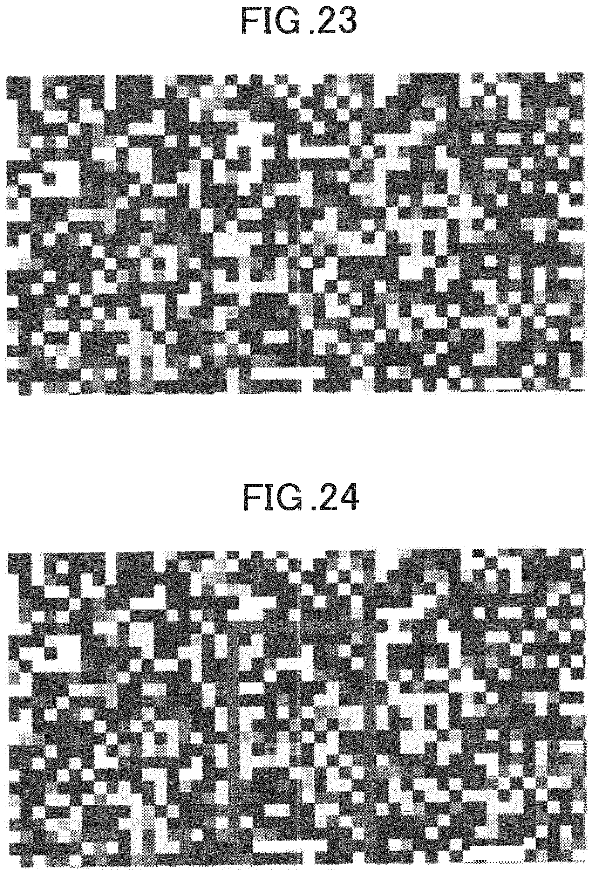

FIG. 22 is an enlarged schematic diagram of a printed wiring board with a Cu wiring pattern, and FIG. 23 is the image data to be printed on it.

### <<Example 6>>

A printed material 6 was prepared in the same way as in Example 5, except that the image data was changed such that the liquid amount per pixel was 10.5 pL at the portion contacting the Cu wiring pattern as shown in FIG. 24.

### <<Example 7>>

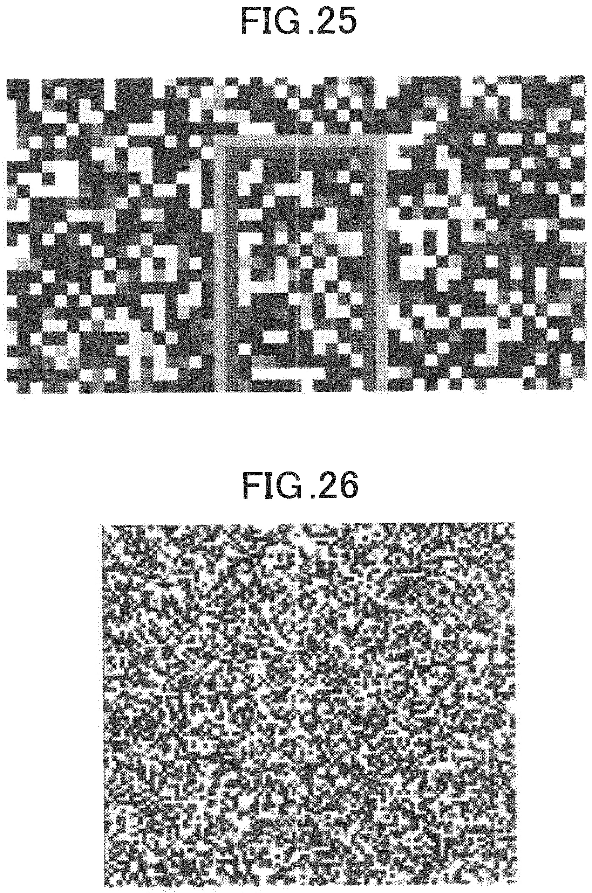

A printed material 7 was prepared in the same way as in Example 5, except that the image data was changed such that the liquid amount per pixel was 10.5 pL at the portion contacting the Cu wiring pattern and 7 pL the portion of one pixel around it and that the thickness varies continuously as shown in FIG. 25.

### <<Example 8>>

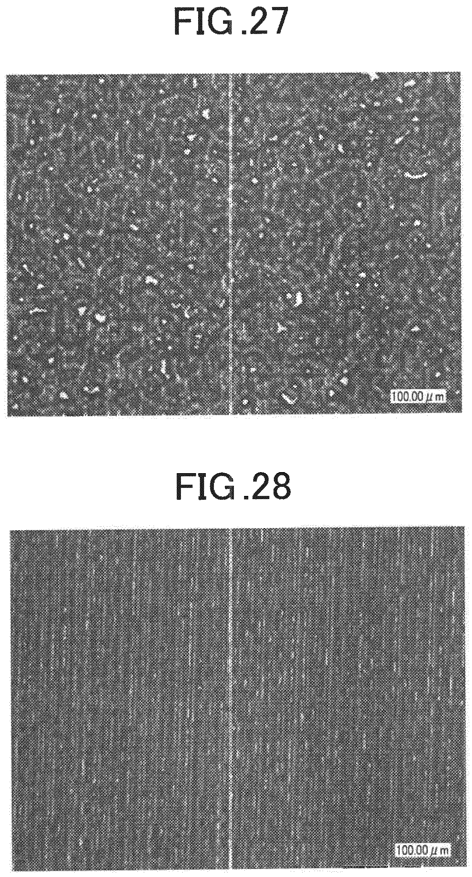

A printed material 8 was prepared in the same way as in Example 5, except that the printing conditions were changed to the following conditions. An optical microscope photograph of the printed material 8 at a magnification of 100 is shown in FIG. 27.
Image data of the solid portion: see FIG. 26 (gray in 256 shades converted to random multi-shade using filtering as described above)
Resolution: 1200 dpi × 1200 dpi (conveying direction)
Number of passes: 2 (600 dpi × 2)
Moving distance of head nozzle in column direction between passes: 21.2 µm
Printing method: block

| | |
|---|---|
| Liquid volume distribution: | 0 to 86 shades 14 pL |
| | 87 to 172 shades 7 pL |
| | 173 to 255 shades 0 pL (no droplet application) |

### <<Example 9>>

Using a linear XY stage with one inkjet print head (KM1800iSHC-C: manufactured by Konica Minolta, nozzle resolution 600 dpi) and a control system (IJCS-1: manufactured by Konica Minolta), a printing pattern was printed on an optical PET film as a board under the following conditions. A printed material 9 was produced through exposure to UV-LED light at a wavelength of 395 nm and irradiation energy of 500 mJ/cm² and a curing process.
Printing Pattern: A hollow circle with a diameter of 100 to 1000 µm is placed on a square of 70 mm × 70 mm.
Image data of the solid portion: see FIG. 31, original image data
Resolution: 2400 dpi × 2400 dpi (conveying direction)
Printing direction (main scanning direction): unidirectional printing
Printing direction (sub scanning direction): forward direction printing
Number of passes: 8 (600 dpi × 8)
Moving distance of head nozzle in column direction between passes: 10.6 µm
Printing method: Random multi-pass, see FIG. 31
Liquid volume distribution: 3.5 pL on entire surface
Head temperature (temperature upon ink ejection): 75°C
Board temperature (temperature upon ink landing): Room temperature (25°C)

### <<Example 10>>

### [Divisional Printing (Number of Image Divisions: 2)]

As shown in FIG. 29, the image data of the solid portion were divided using image processing software such that pixels do not overlap when overprinted and such that the respective pixels were not in the same order as the rows and columns in the array and did not have a certain periodicity. Thus, division image data No. 1 and No. 2 were prepared. Then, division image data were printed repeatedly in sequence under the following conditions.

A printed material 12 was prepared in the same way as in Example 9, except that the image data and the printing conditions were changed to the following conditions.
Printing Pattern: A hollow circle with a diameter of 100 to 1000 µm is placed on a square of 70 mm × 70 mm.
Image data of the solid portion: see FIG. 29, original image data
Number of image divisions: 2
Division image data: see FIG. 29, division image data
Resolution: 2400 dpi × 2400 dpi (conveying direction)
Number of passes: 8 (600 dpi × 8)
Printing direction (main scanning direction): unidirectional printing
Printing direction (sub scanning direction): forward direction printing
Moving distance of head nozzle in column direction between passes: 10.6 µm
Printing method: Random multi-pass, see FIG. 29
Liquid volume distribution: 3.5 pL on entire surface
Head temperature (temperature upon ink ejection): 75°C
Board temperature (temperature upon ink landing): Room temperature (25°C)

### <<Example 11>>

### [Divisional Printing (Number of Image Divisions: 4)]

A printed material 13 was prepared in the same way as in Example 10, except that the image data and the printing conditions were changed to the following conditions.
Printing Pattern: A hollow circle with a diameter of 100 to 1000 µm is placed on a square of 70 mm × 70 mm.
Image data of the solid portion: see FIG. 30A and B, original image data
Number of image divisions: 4
Division image data: see FIG. 30A and B, division image data
Resolution: 2400 dpi × 2400 dpi (conveying direction)
Number of passes: 16 (600 dpi × 16)
Printing direction (main scanning direction): unidirectional printing
Printing direction (sub scanning direction): forward direction printing
Moving distance of head nozzle in column direction between passes: 10.6 µm
Printing method: Random multi-pass, see FIG. 30A and B
Liquid volume distribution: 3.5 pL on entire surface
Head temperature (temperature upon ink ejection): 75°C
Board temperature (temperature upon ink landing): Room temperature (25°C)

### <<Example 12>>

### [Bidirectional Printing]

A printed material 14 was prepared in the same way as in Example 10, except that the printing conditions were changed to the following conditions.
Printing Pattern: A hollow circle with a diameter of 100 to 1000 µm is placed on a square of 70 mm × 70 mm.
Image data of the solid portion: see FIG. 38, original image data
Number of image divisions: 2
Division image data: see FIG. 38, division image data
Resolution: 2400 dpi × 2400 dpi (conveying direction)
Number of passes: 8 (600 dpi × 8)
Printing direction (main scanning direction): bidirectional printing
Printing direction (sub scanning direction): forward direction printing
Moving distance of head nozzle in column direction between passes: 10.6 µm
Printing method: Random multi-pass, see FIG. 38
Liquid volume distribution: 3.5 pL on entire surface
Head temperature (temperature upon ink ejection): 75°C
Board temperature (temperature upon ink landing): Room temperature (25°C)

### <<Example 13>>

### [Backward and Forward Printing]

A printed material 15 was prepared in the same way as in Example 10, except that the printing conditions were changed to the following conditions.
Printing Pattern: A hollow circle with a diameter of 100 to 1000 µm is placed on a square of 70 mm × 70 mm.
Image data of the solid portion: see FIG. 39, original image data
Number of image divisions: 2
Division image data: see FIG. 39, division image data
Resolution: 2400 dpi × 2400 dpi (conveying direction)
Number of passes: 8 (600 dpi × 8)
Printing direction (main scanning direction): unidirectional printing
Printing direction (sub scanning direction): Backward and forward printing
Moving distance of head nozzle in column direction between passes: 10.6 µm
   21.2 µm (between scan 3 and scan 4, between scan 7 and scan 8)
Printing method: Random multi-pass, see FIG. 39
Liquid volume distribution: 3.5 pL on entire surface
Head temperature (temperature upon ink ejection): 75°C
Board temperature (temperature upon ink landing): Room temperature (25°C)

### <<Example 14>>

### [Random Drop multi-pass Method and Random multi-pass Method]

Using a linear XY stage with one inkjet print head (KM1800iSHC-C: manufactured by Konica Minolta, nozzle resolution 600 dpi) and a control system (IJCS-1: manufactured by Konica Minolta), a printing pattern was printed on an optical PET film as a board under the following conditions. A printed material 16 was produced through exposure to UV-LED light at a wavelength of 395 nm and irradiation energy of 500 mJ/cm² and a curing process.

The liquid amount distribution was done corresponding to the shade of each pixel in the image data, and printed material 16 was produced.
Printing Pattern: A hollow circle with a diameter of 100 to 1000 µm is placed on a square of 70 mm × 70 mm
Image data of the solid portion: see FIG. 43 image data (30% gray in 256 shades converted to random multi-shaded gray using noise filtering in image processing software Photoshop 2020 by Adobe)
Resolution: 2400 dpi × 2400 dpi (conveying direction)
Number of passes: 8 (600 dpi × 8)
Printing direction (main scanning direction): unidirectional printing
Printing direction (sub scanning direction): forward direction printing
Moving distance of head nozzle in column direction between passes: 10.6 µm
Printing method: Random multi-pass, see FIG. 43

| | |
|---|---|
| Liquid volume distribution: | 0 to 86 shades 7 pL |
| | 87 to 172 shades 3.5 pL |
| | 173 to 255 shades 0 pL (no droplet application) |

Head temperature (temperature upon ink ejection): 75°C
Board temperature (temperature upon ink landing): Room temperature (25°C)

### <<Example 15>>

### [Divisional Printing on Printed Wiring Board (Number of image divisions: 2)]

A printed material 17 was prepared in the same way as in Example 10, except that the board was changed to a printed wiring board of glass epoxy board with Cu wiring pattern having Cu thickness of 15 µm and L/S (line/space) is 100 µm/100 µm.

### <<Comparative Example 1>>

A printed material 9 was prepared in the same way as in Example 1, except that the printing conditions were changed to the following conditions. An optical microscope photograph of the printed material 9 at a magnification of 100 is shown in FIG. 28.
Printing Pattern: A hollow circle with a diameter of 100 to 1000 µm is placed on a square of 70 mm × 70 mm
Image data of the solid portion: see FIG. 15
Resolution: 2400 dpi × 2400 dpi (conveying direction)
Number of passes: 4 (600 dpi × 4)
Moving distance of head nozzle in column direction between passes: 10.6 µm
Printing method: Block
Liquid volume distribution: 3.5 pL on entire surface

### <<Comparative Example 2>>

A printed material 10 was prepared in the same way as in Comparative Example 1, except that the board was changed to a printed wiring board of glass epoxy board with Cu wiring pattern having Cu thickness of 15 µm and L/S (line/space) is 100 µm/100 µm.

FIG. 22 is an enlarged schematic diagram of a printed wiring board with a Cu wiring pattern, and FIG. 23 is the image data to be printed on it.

### <<Comparative Example 3>>

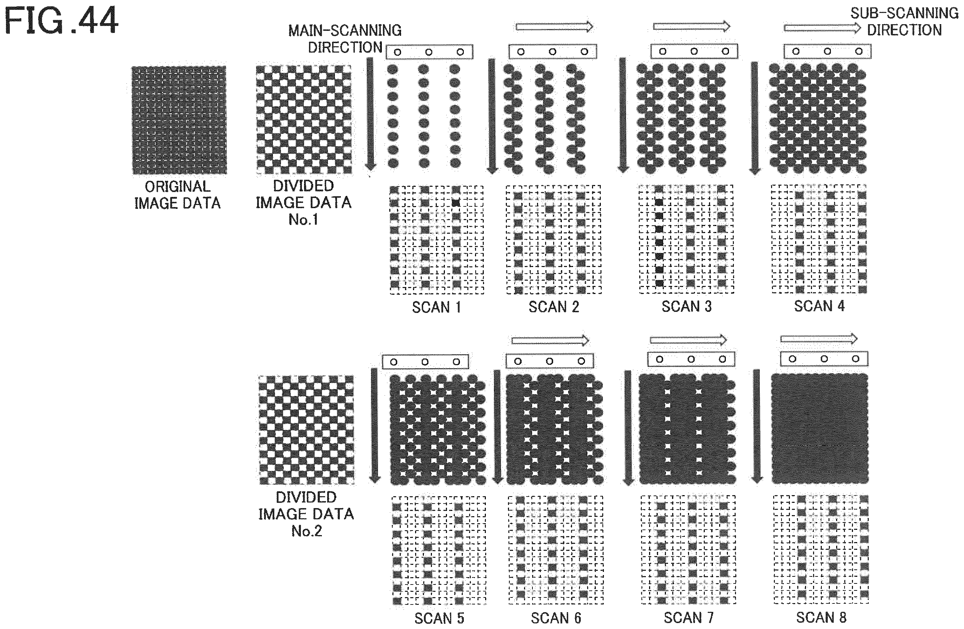

A printed material 18 was prepared in the same way as in Example 10, except that the printing conditions were changed to the following conditions.
Printing Pattern: A hollow circle with a diameter of 100 to 1000 µm is placed on a square of 70 mm × 70 mm
Image data of the solid portion: see FIG. 44, original image data
Number of image divisions: 2
Division image data: see FIG. 44, division image data
Resolution: 2400 dpi × 2400 dpi (conveying direction)
Number of passes: 8 (600 dpi × 8)
Printing direction (main scanning direction): unidirectional printing
Printing direction (sub scanning direction): forward direction printing
Moving distance of head nozzle in column direction between passes: 10.6 µm
Printing method: Interleaving, see FIG. 44
Liquid volume distribution: 3.5 pL on entire surface
Head temperature (temperature upon ink ejection): 75°C
Board temperature (temperature upon ink landing): Room temperature (25°C)

### [Evaluation]

### <Evaluation of Streak>

The pattern on the obtained printed material was visually checked and evaluated for streaks.
⊚ (double circle): No streaks are observed.
o (circle): A slight streak(s) is perceived, but it is not very prominent.
△ (triangle): A streak(s) is perceived.
× (cross mark): A prominent streak(s) is perceived.

### <Glossiness>

Using a Handy type Gloss Meter (PG-II: manufactured by Nippon Denshoku Kogyo), glossiness at 60 degrees was measured in the parallel and perpendicular directions to the conveying direction. When streaks are generated, the values of glossiness change significantly between parallel and perpendicular directions. When no streaks are generated, the values in the parallel and perpendicular directions are almost the same. When the glassiness values in the parallel and perpendicular directions differ by 3 or more, a prominent streak(s) is perceived.

### <Average Layer Thickness>

Using a layer thickness meter (Digimicro MH-15M+TC-101A: manufactured by Nikon Corporation), measurements were made at five points, four corners and the center of a 70 mm × 70 mm square of the printing pattern portion, and the average layer thickness was calculated.

### <Pinhole>

The printing pattern was observed with an optical microscope and the presence of pinholes was evaluated. Local pinholes may deteriorate the adhesiveness of a bulk.

### <Pattern Formability>

A hollow circle with a diameter of 500 µm was observed with an optical microscope and evaluated.
⊚ (double circle): The outline of the hollow circle almost represents the image to be printed.
o (circle): The outline of the hollow circle is slightly rough, but there is no problem with pattern formability.
△ (triangle): The outline of the hollow circle is highly rough and the pattern formability is deteriorated.
× (cross mark): The outline of the hollow circle is collapsed, and pattern formability is not achieved.

The following evaluations were performed on Examples 5 to 8 and Comparative Example 2, in which printed wiring boards were used as boards.

### <Adhesiveness>

A crosscut was made in the printing pattern portion in accordance with the crosscut method of JIS K5600, and an adhesive tape was applied to the portion and then peeled off. The remaining adhesion of the printing pattern was observed and evaluated for adhesiveness.
⊚ (double circle): Adhesion residual rate is 100%.
o (circle): Adhesion residual rate is 80% or more and less than 100%.
△ (triangle): Adhesion residual rate is 60% or more and less than 80%.
× (cross mark): Adhesion residual rate is less than 60%.

### <Solder Resistance>

After immersion in a 260°C solder bath for 10 seconds three times, a crosscut was made in the printing pattern portion in accordance with the crosscut method of JIS K5600, and an adhesive tape was applied to the portion and then peeled off. The remaining adhesion of the printing pattern was observed and evaluated for solder resistance.
⊚ (double circle): Adhesion residual rate is 100%.
o (circle): Adhesion residual rate is 80% or more and less than 100%.
△ (triangle): Adhesion residual rate is 60% or more and less than 80%.
× (cross mark): Adhesion residual rate is less than 60%.

### <Step Following Property>

After immersion in a 260°C solder bath for 10 seconds three times, a crosscut was made in the printing pattern portion that spans areas with and without Cu wiring pattern in accordance with the crosscut method of JIS K5600, and an adhesive tape was applied to the portion and then peeled off. The state of peeling of the printing pattern was observed and evaluated for adhesiveness. When the layer thickness is thin at the step of the Cu wiring pattern, the adhesiveness at the step is reduced.
⊚ (double circle): There is no peeling at the step with Cu pattern.
o (circle): Thin linear peeling is observed at a part of the step with Cu pattern.
∘△ (circle and triangle): Continuous linear peeling is observed at the step with Cu pattern.
△ (triangle): There is significant peeling at the step with Cu pattern, and the Cu surface is exposed.
× (cross mark): Peeling occurs over the entire surface at the step with Cu pattern.

The above experimental conditions and evaluation results are summarized in Tables I and II.

**TABLE I**

| Remarks | Present invention 1 | Present invention 2 | Present invention 3 | Present invention 4 | Present invention 5 | Present invention 6 | Present invention 7 | Present i nvention 8 |
|---|---|---|---|---|---|---|---|---|
| Printed material No. | 1 | 2 | 3 | 4 | 5 | 6 | 7 | 8 |
| Board | PET | PET | PET | PET | Printed wiring board | Printed wiring board | Printed wiring board | Printed wiring board |
| Print data | Random multi-shaded | Solid | Random multi-shaded | Random multi-shaded | Random multi-shaded | Random multi-shaded | Random multi-shaded | Random multi-shaded |
| Resolution (dpi) | 2400 × 3000 | 1200 × 1200 | 2400 × 2400 | 2400 × 2400 | 2400 × 2400 | 2400 × 2400 | 2400 × 2400 | 1200 × 1200 |
| Shade | 2 | 2 | 3 | 3 | 3 | 3 | 3 | 3 |
| Liquid volume distribution (pL) | 0, 3.5 | 0, 10.5 | 0, 3.5, 7 | 0, 3.5, 7 | 0, 3.5, 7 | 0, 3.5, 7 | 0, 3.5, 7 | 0, 7, **14** |
| Printing method | Block | Random landing | Block | Block | Block | Block | Block | Block |
| Number of image divisions | 1 | 1 | 1 | 1 | 1 | 1 | 1 | 1 |
| Number of passes | 4 | 8 | 4 | 4 | 4 | 4 | 4 | 2 |
| Printing direction (main-scanning) | Unidirectional | Unidirectional | Unidirectional | Unidirectional | Unidirectional | Unidirectional | Unidirectional | Unidirectional |
| Printing direction (sub-scanning) | Forward | Forward | Forward | Forward | Forward | Forward | Forward | Forward |
| Edge | Without edge | Without edge | Without edge | With edge | Without edge | Without edge | Without edge | Without edge |
| Edge at step | Without edge | Without edge | Without edge | Without edge | Without edge | With edge | With edge (continuous) | Without edge |
| Average thickness (µm) | 26 | 23 | 24 | 24 | 24 | 24 | 24 | 14 |
| Streak | ○ | ○ | ⊚ | ⊚ | ⊚ | ⊚ | ⊚ | ○ |
| Glossiness (parallel) | 9.7 | 8.8 | 5.9 | 5.9 | 6.4 | 6.4 | 6.4 | 8.6 |
| Glossiness (perpendicular) | 9.8 | 9.2 | 6.1 | 6.1 | 6.7 | 6.7 | 6.7 | 9.2 |
| Pinhole | Without pinhole | Without pinhole | Without pinhole | Without pinhole | Without pinhole | Without pinhole | Without pinhole | With pinhole |
| Pattern formability | ○ | ○ | ○ | ⊚ | ○ | ○ | ○ | ○ |
| Adhesiveness | - | - | - | - | ⊚ | ⊚ | ⊚ | ○ |
| Solder resistance | - | - | - | - | ⊚ | ⊚ | ⊚ | ○ |
| Step following ability | - | - | - | - | O△ | ○ | ⊚ | - |

**TABLE II**

| Remarks | Present invention 9 | Present invention 10 | Present invention 11 | Present invention 12 | Present invention 13 | Present invention 14 | Present invention 15 | Comparative example 1 | Comparative example 2 | Comparative example 3 |
|---|---|---|---|---|---|---|---|---|---|---|
| Printed material No. | 11 | 12 | 13 | 14 | 15 | 16 | 17 | 9 | 10 | 18 |
| Board | PET | PET | PET | PET | PET | PET | Printed wiring board | PET | Printed wiring board | PET |
| Print data | Solid | Solid | Solid | Solid | Solid | Random multi-shaded | Solid | Solid | Solid | Solid |
| Resolution (dpi) | 2400 × 2400 | 2400 × 2400 | 2400 × 2400 | 2400 × 2400 | 2400 × 2400 | 2400 × 2400 | 2400 × 2400 | 2400 × 2400 | 2400 × 2400 | 2400 × 2400 |
| Shade | 2 | 2 | 2 | 2 | 2 | 3 | 2 | 2 | 2 | 2 |
| Liquid volume distribution (pL) | 0, 3.5 | 0, 3.5 | 0, 3.5 | 0. 3.5 | 0, 3.5 | 0, 3.5, 7 | 0, 3.5 | 0, 3.5 | 0. 3.5 | 0, 3.5 |
| Printing method | Random landing | Random landing | Random landing | Random landing | Random landing | Random landing | Random landing | Block | Block | Interleaving |
| Number of image divisions | 1 | 2 | 4 | 2 | 2 | 1 | 2 | 1 | 1 | 2 |
| Number of passes | 8 | 8 | 16 | 8 | 8 | 8 | 8 | 4 | 4 | 8 |
| Printing direction (main-scanning) | Unidirectional | Unidirectional | Unidirectional | Bidirectional | Unidirectional | Unidirectional | Unidirectional | Unidirectional | Unidirectional | Unidirectional |
| Printing direction (sub-scanning) | Forward | Forward | Forward | Forward | Back and forth | Forward | Forward | Forward | Forward | Forward |
| Edge | Without edge | Without edge | Without edge | Without edge | Without edge | Without edge | Without edge | Without edge | Without edge | Without edge |
| Edge at step | Without edge | Without edge | Without edge | Without edge | Without edge | Without edge | Without edge | Without edge | Without edge | Without edge |
| Average thickness (µm) | 29 | 29 | 29 | 29 | 29 | 24 | 29 | 29 | 30 | 29 |
| Streak | ○ | ⊚ | ⊚ | ⊚ | ⊚ | ⊚ | ⊚ | × | × | × |
| Glossiness (parallel) | 6.2 | 6.5 | 6.4 | 6.8 | 6.3 | 6.3 | 6.5 | 21.9 | 22.3 | 18.4 |
| Glossiness (perpendicular) | 6.7 | 6.7 | 6.4 | 6.7 | 6.4 | 6.3 | 6.7 | 10.1 | 11.3 | 12.1 |
| Pinhole | Without pinhole | Without pinhole | Without pinhole | Without pinhole | Without pinhole | Without pinhole | Without pinhole | Without pinhole | Without pinhole | Without pinhole |
| Pattern formability | ○ | ○ | ⊚ | ○ | ⊚ | ○ | ○ | ○ | ○ | ○ |
| Adhesiveness | - | - | - | - | - | - | ○ | - | △ | - |
| Solder resistance | - | - | - | - | - | - | ○ | - | ○ | - |
| Step following ability | - | - | - | - | - | - | - | - | ○△ | - |

As is clear from the evaluation results, etc., shown in Tables I and II above, the patterns formed by the method of pattern formation of the present invention are superior to those of the comparative examples in each of the above evaluation items.

For the random multi-pass method, it can be seen that further reduction in streaks and speckles and improvement of pattern formability can be revealed by using division printing, bidirectional printing, or backward and forward printing. In addition, it can be seen that streaks and speckles are reduced by applying the random drop multi-pass method to the random multi-pass method.

### Industrial Applicability

The above means of the present invention provides a method of pattern formation by an inkjet method with high definition, no streaks or speckles, uniform insulating and conductive properties, even when using inks containing functional materials such as insulators and conductors, and good adhesion of the coating layer.

### Reference Signs List

- 1: Inkjet Printing Device
- 2: Carriage
- 3: Head
- 4: X-Direction Linear Stage
- 5: Table
- 6: Y-Direction Linear Stage
- 7: Printed Wiring Board
- 8: Copper Wiring Portion (Height: 15 µm, Width: 100 µm)
- 9: Ink Ejecting Device
- 10: Board (Print Medium)
- 100: Inkjet Printing Device

## Claims

1. A method of pattern formation by an inkjet printing method based on image data of a pattern, the pattern formation including movements perpendicular to a nozzle column direction of an ink ejecting device (9) in which multiple nozzle holes are arranged in a column, movements parallel to the nozzle column direction, and ejection of a droplet of an ink from a nozzle onto a board (10) as a print medium, the method comprising and **characterized in that**:
using an ink having a ratio η2/η1 equal to or more than 100, the η1 being a viscosity at a temperature upon ejection, the η2 being a viscosity at a temperature upon landing; and
controlling a liquid amount of the ink used to form a coating layer of a dot constituting the pattern to be formed on the board (10) corresponding to shade or density of each pixel constituting the image data of the pattern so as not to have a certain periodicity with neighboring dots and such that the coating layer of the pattern is not entirely even,
wherein control is made such that a liquid amount of a dot that forms an outer edge surface at a boundary between an inside and an outside of a bottom surface of a convex portion of the board (10) varies continuously from a surface in contact with the convex portion to a surface in an outward direction and an average thickness of the coating layer of the dot constituting the pattern is 15 µm or more.

2. A method of pattern formation by an inkjet printing method based on image data of a pattern, the pattern formation including movements perpendicular to a nozzle column direction of an ink ejecting device (9) in which multiple nozzle holes are arranged in a column, movements parallel to the nozzle column direction, and ejection of a droplet of an ink from a nozzle onto a board (10) as a print medium, the method comprising and **characterized in that**:
using an ink having a ratio η2/η1 equal to or more than 100, the η1 being a viscosity at a temperature upon ejection, the η2 being a viscosity at a temperature upon landing;
multiple times of landing of the droplet of the ink that is used to form a coating layer of a dot constituting the pattern to be formed on the board, and
controlling a position of the dot where the droplet lands so as not to be in the order of a row or a column of an array of pixels constituting the image data, and so as not to have a certain periodicity,
wherein control is made such that a liquid amount of a dot that forms an outer edge surface at a boundary between an inside and an outside of a bottom surface of a convex portion of the board (10) varies continuously from a surface in contact with the convex portion to a surface in an outward direction and an average thickness of the coating layer of the dot constituting the pattern is 15 µm or more.

3. A method of pattern formation by an inkjet printing method based on image data of a pattern, the pattern formation including movements of an ink ejecting device (9) having multiple nozzle holes or a board (10) as a print medium and ejection of a droplet of an ink from a nozzle of the ink ejecting device (9) onto the board (10) as the print medium, the method comprising and **characterized in that**:
using an ink having a ratio η2/η1 equal to or more than 100, the η1 being a viscosity at a temperature upon ejection, the η2 being a viscosity at a temperature upon landing;
multiple times of landing of the droplet of the ink that is used to form a coating layer of a dot constituting the pattern to be formed on the board, and
controlling a position of the dot where the droplet lands so as not to have a certain periodicity in a main scanning direction or in a sub scanning direction of the ink ejecting device (9), and so as not to be successive in the main scanning direction,
wherein control is made such that a liquid amount of a dot that forms an outer edge surface at a boundary between an inside and an outside of a bottom surface of a convex portion of the board (10) varies continuously from a surface in contact with the convex portion to a surface in an outward direction and an average thickness of the coating layer of the dot constituting the pattern is 15 µm or more.

4. The method of pattern formation according to claim 3, wherein
the image data of the pattern are divided into multiple pieces such that pixels do not overlap when overprinted and such that a position of the dot where the droplet lands does not have a certain periodicity in the main scanning direction or in the sub scanning direction of the ink ejecting device (9) and is not successive in the main scanning direction, and
the divided image data are sequentially overprinted.

5. The method of pattern formation according to claim 3 or claim 4, wherein
the ink ejecting device (9) relatively moves back and forth in the main scanning direction and ejects a droplet of ink in both a forward pass and a backward pass.

6. The method of pattern formation according to any one of claim 3 to claim 5, wherein
the ink ejecting device (9) relatively moves in a combination of a forward direction and an opposite direction with respect to the sub scanning direction.

7. The method of pattern formation according to any one of claim 3 to claim 6, wherein
a liquid amount of the ink that is used to form the coating layer of the dot constituting the pattern to be formed on the board (10) is controlled corresponding to shade or density of each pixel constituting the image data of the pattern so as not to have a certain periodicity with neighboring dots and such that the coating layer of the pattern is not entirely even.

8. The method of pattern formation according to any one of claim 1 to claim 7, wherein
control is made such that a liquid amount of the ink per dot that form an inner edge of a patterned portion at a boundary between the patterned portion and a non-patterned portion formed on the board (10) is substantially the same.

9. The method of pattern formation according to any one of claim 1 to claim 8, wherein
control is made such that a liquid amount of the ink per dot that form an outer edge of a boundary between an inside and an outside of a bottom of a convex portion of the board (10) is more than a liquid amount of the ink per dot that form an edge of the convex portion.

10. The method of pattern formation according to any one of claim 1 to claim 9, wherein
a liquid amount of the ink that lands and forms a coating layer of the dot constituting the pattern is changed in multiple levels.

11. The method of pattern formation according to any one of claim 1 to claim 10, wherein
the ink is one of a hot-melt type ink, a gelled type ink, and a thixotropic type ink.

12. The method of pattern formation according to any one of claim 1 to claim 11, wherein
the ink is a solder resist ink.

13. An inkjet printing device (1) that forms a pattern based on image data of a pattern using the method of pattern formation according to any one of claim 1 to claim 12.

## Patentansprüche

1. Verfahren zur Musterbildung durch ein Tintenstrahldruckverfahren auf der Grundlage von Bilddaten eines Musters, wobei die Musterbildung Bewegungen senkrecht zur Düsenreihenrichtung einer Tintenausstoßvorrichtung (9), in der mehrere Düsenlöcher in einer Reihe angeordnet sind, Bewegungen parallel zur Düsenreihenrichtung und den Ausstoß eines Tintentropfens aus einer Düse auf eine Platte (10) als Druckmedium umfasst, wobei das Verfahren umfasst und **dadurch gekennzeichnet ist, dass**
eine Tinte mit einem Verhältnis η2/η1 von mindestens 100 verwendet wird, wobei η1 die Viskosität bei der Temperatur beim Ausstoßen und η2 die Viskosität bei der Temperatur beim Auftreffen ist; und
steuern einer Flüssigkeitsmenge der Tinte, die verwendet wird, um eine Beschichtungsschicht eines Punktes zu bilden, der das auf der Platte (10) zu bildende Muster bildet, entsprechend der Schattierung oder Dichte jedes Pixels, das die Bilddaten des Musters bildet, so dass keine bestimmte Periodizität mit benachbarten Punkten auftritt und die Beschichtungsschicht des Musters nicht vollständig gleichmäßig ist,
wobei die Steuerung so erfolgt, dass eine Flüssigkeitsmenge eines Punktes, der eine Außenkantenfläche an einer Grenze zwischen einer Innenseite und einer Außenseite einer Bodenfläche eines konvexen Abschnitts der Platte (10) bildet, sich kontinuierlich von einer Oberfläche, die mit dem konvexen Abschnitt in Kontakt steht, zu einer Oberfläche in einer nach außen gerichteten Richtung ändert und eine durchschnittliche Dicke der Beschichtungsschicht des Punktes, der das Muster bildet, 15 µm oder mehr beträgt.

2. Verfahren zur Musterbildung durch ein Tintenstrahldruckverfahren auf der Grundlage von Bilddaten eines Musters, wobei die Musterbildung Bewegungen senkrecht zu einer Düsenreihrichtung einer Tintenausstoßvorrichtung (9), in der mehrere Düsenlöcher in einer Reihe angeordnet sind, Bewegungen parallel zur Düsenreihrichtung und das Ausstoßen eines Tintentropfens aus einer Düse auf eine Platte (10) als Druckmedium umfasst, wobei das Verfahren umfasst und **dadurch gekennzeichnet ist, dass**:
eine Tinte mit einem Verhältnis η2/η1 von 100 oder mehr verwendet wird, wobei η1 die Viskosität bei einer Temperatur beim Ausstoßen und η2 die Viskosität bei einer Temperatur beim Auftreffen ist;
der Tropfen der Tinte, die zur Bildung einer Beschichtungsschicht eines Punktes verwendet wird, der das auf der Platte zu bildende Muster bildet, mehrfach aufgetragen wird, und
eine Position des Punktes, an dem der Tropfen auftrifft, gesteuert wird, so dass er nicht in der Reihenfolge einer Zeile oder Spalte einer Anordnung von Pixeln liegt, die die Bilddaten bilden, und so dass er keine bestimmte Periodizität aufweist,
wobei die Steuerung so erfolgt, dass die Flüssigkeitsmenge eines Punktes, der eine Außenkantenfläche an einer Grenze zwischen einer Innenseite und einer Außenseite einer Unterseite eines konvexen Abschnitts der Platte (10) bildet, sich kontinuierlich von einer Oberfläche, die mit dem konvexen Abschnitt in Kontakt steht, zu einer Oberfläche in einer nach außen gerichteten Richtung ändert und eine durchschnittliche Dicke der Beschichtungsschicht des Punktes, der das Muster bildet, 15 µm oder mehr beträgt.

3. Verfahren zur Musterbildung durch ein Tintenstrahldruckverfahren auf der Grundlage von Bilddaten eines Musters, wobei die Musterbildung Bewegungen einer Tintenausstoßvorrichtung (9) mit mehreren Düsenöffnungen oder einer Platte (10) als Druckmedium und den Ausstoß eines Tintentropfens aus einer Düse der Tintenausstoßvorrichtung (9) auf die Platte (10) als Druckmedium umfasst, wobei das Verfahren umfasst und **dadurch gekennzeichnet ist, dass**:
eine Tinte mit einem Verhältnis η2/η1 von mindestens 100 verwendet wird, wobei η1 die Viskosität bei der Temperatur beim Ausstoßen und η2 die Viskosität bei der Temperatur beim Auftreffen ist;
der Tropfens der Tinte, die zur Bildung einer Beschichtungsschicht eines Punktes verwendet wird, der das auf der Platte zu bildende Muster bildet, mehrfach aufgetragen wird, und
eine Position des Punktes, an dem der Tropfen auftrifft, so gesteuert wird, dass er keine bestimmte Periodizität in einer Haupt-Abtastrichtung oder in einer Nebenabtastrichtung der Tintenausstoßvorrichtung (9) aufweist und so dass er in der Hauptabtastrichtung nicht aufeinanderfolgend ist,
wobei die Steuerung so erfolgt, dass die Flüssigkeitsmenge eines Punktes, der eine Außenkantenfläche an einer Grenze zwischen einer Innenseite und einer Außenseite einer Unterseite eines konvexen Abschnitts der Platte (10) bildet, sich kontinuierlich von einer Oberfläche, die mit dem konvexen Abschnitt in Kontakt steht, zu einer Oberfläche in einer nach außen gerichteten Richtung ändert und eine durchschnittliche Dicke der Beschichtungsschicht des Punktes, der das Muster bildet, 15 µm oder mehr beträgt.

4. Verfahren zur Musterbildung gemäß Anspruch 3, wobei
die Bilddaten des Musters in mehrere Teile unterteilt werden, so dass sich die Pixel beim Überdrucken nicht überlappen und dass eine Position des Punktes, an dem der Tropfen auftrifft, keine bestimmte Periodizität in der Hauptabtastrichtung oder in der Nebenabtastrichtung der Tintenausstoßvorrichtung (9) aufweist und in der Hauptabtastrichtung nicht aufeinanderfolgend ist, und
die unterteilten Bilddaten nacheinander überdruckt werden.

5. Verfahren zur Musterbildung gemäß Anspruch 3 oder Anspruch 4, wobei
die Tintenausstoßvorrichtung (9) sich relativ in der Hauptabtastrichtung hin und her bewegt und sowohl in einem Vorwärtsdurchgang als auch in einem Rückwärtsdurchgang einen Tintentropfen ausstößt.

6. Verfahren zur Musterbildung gemäß einem der Ansprüche 3 bis 5, wobei
sich die Tintenausstoßvorrichtung (9) relativ in einer Kombination aus einer Vorwärtsrichtung und einer entgegengesetzten Richtung in Bezug auf die Teilabtastrichtung bewegt.

7. Verfahren zur Musterbildung gemäß einem der Ansprüche 3 bis 6, wobei
die Flüssigkeitsmenge der Tinte, die zum Bilden der Beschichtungsschicht des Punktes verwendet wird, der das auf der Platte (10) zu bildende Muster bildet, entsprechend der Schattierung oder Dichte jedes Pixels, das die Bilddaten des Musters bildet, so gesteuert wird, dass sie keine bestimmte Periodizität mit benachbarten Punkten aufweist und dass die Beschichtungsschicht des Musters nicht vollständig gleichmäßig ist.

8. Verfahren zur Musterbildung gemäß einem der Ansprüche 1 bis 7, wobei
die Steuerung so erfolgt, dass die Flüssigkeitsmenge der Tinte pro Punkt, die eine Innenkante eines gemusterten Abschnitts an einer Grenze zwischen dem gemusterten Abschnitt und einem nicht gemusterten Abschnitt bildet, der auf der Platte (10) ausgebildet ist, im Wesentlichen gleich ist.

9. Verfahren zur Musterbildung gemäß einem der Ansprüche 1 bis 8, wobei
die Steuerung derart erfolgt, dass die Flüssigkeitsmenge der Tinte pro Punkt, die eine Außenkante einer Grenze zwischen einer Innenseite und einer Außenseite eines Bodens eines konvexen Abschnitts der Platte (10) bildet, größer ist als die Flüssigkeitsmenge der Tinte pro Punkt, die eine Kante des konvexen Abschnitts bildet.

10. Verfahren zur Musterbildung gemäß einem der Ansprüche 1 bis 9, wobei
eine Flüssigkeitsmenge der Tinte, die auftrifft und eine Beschichtungsschicht des Punktes bildet, der das Muster bildet, in mehreren Stufen verändert wird.

11. Verfahren zur Musterbildung gemäß einem der Ansprüche 1 bis 10, wobei
die Tinte eine Heißschmelztinte, eine Gel-Tinte oder eine thixotrope Tinte ist.

12. Verfahren zur Musterbildung gemäß einem der Ansprüche 1 bis 11, wobei
die Tinte eine Lötstopp-Tinte ist.

13. Tintenstrahldruckvorrichtung (1), die ein Muster auf der Grundlage von Bilddaten eines Musters unter Verwendung des Verfahrens zur Musterbildung gemäß einem der Ansprüche 1 bis 12 bildet.

## Revendications

1. Une méthode de formation de motif par une méthode d'impression jet d'encre, basée sur des données d'image d'un motif, la formation de motif incluant des mouvements perpendiculaires à une direction de colonne de buse d'un dispositif d'éjection d'encre (9) dans lequel plusieurs trous de buse sont disposés dans une colonne, des mouvements parallèles à la direction de colonne de buse, et éjection d'une gouttelette d'une encre à partir d'une buse sur un tableau (10) comme support d'impression, la méthode comprenant et **caractérisée en ce que** :
utiliser une encre ayant un rapport de η2/η1 égal ou supérieur à 100, le η1 étant une viscosité à une température à l'éjection, le η2 étant une viscosité à une température à l'atterrissage ; et
contrôler une quantité liquide de l'encre utilisée pour former une couche de revêtement d'un point constituant le motif à former sur le tableau (10) correspondant à la teinte ou à la densité de chaque pixel constituant les données d'image du motif, afin de ne pas avoir une certaine périodicité avec des points voisins, et de sorte que la couche de revêtement du motif n'est pas entièrement à égalité,
dans laquelle du contrôle est fait de sorte qu'une quantité liquide d'un point qui forme une surface de bord extérieur à une frontière entre un intérieur et un extérieur d'une surface de fond d'une partie convexe du tableau (10) varie continuellement d'une surface en contact avec la partie convexe à une surface dans une direction extérieure, et une épaisseur moyenne de la couche de revêtement du point constituant le motif est de 15 µm ou plus.

2. Une méthode de formation de motif par une méthode d'impression jet d'encre, basée sur des données d'image d'un motif, la formation de motif incluant des mouvements perpendiculaires à une direction de colonne de buse d'un dispositif d'éjection d'encre (9) dans lequel plusieurs trous de buse sont disposés dans une colonne, des mouvements parallèles à la direction de colonne de buse, et éjection d'une gouttelette d'une encre à partir d'une buse sur un tableau (10) comme support d'impression, la méthode comprenant et **caractérisée en ce que** :
utiliser une encre ayant un rapport de η2/η1 égal ou supérieur à 100, le η1 étant une viscosité à une température à l'éjection, le η2 étant une viscosité à une température à l'atterrissage ;
plusieurs fois d'atterrissage de la gouttelette de l'encre qui est utilisée pour former une couche de revêtement d'un point constituant le motif à former sur le tableau, et
contrôler une position du point où la gouttelette atterrit, afin de ne pas être dans l'ordre d'une ligne ou d'une colonne d'un tableau de pixels constituant les données d'image, et afin de ne pas avoir une certaine périodicité,
dans laquelle du contrôle est fait de sorte qu'une quantité liquide d'un point qui forme une surface de bord extérieur à une frontière entre un intérieur et un extérieur d'une surface de fond d'une partie convexe du tableau (10) varie continuellement d'une surface en contact avec la partie convexe à une surface dans une direction extérieure, et une épaisseur moyenne de la couche de revêtement du point constituant le motif est de 15 µm ou plus.

3. Une méthode de formation de motif par une méthode d'impression jet d'encre, basée sur des données d'image d'un motif, la formation de motif incluant des mouvements perpendiculaires à une direction de colonne de buse d'un dispositif d'éjection d'encre (9) dans lequel plusieurs trous de buse sont disposés dans une colonne, des mouvements parallèles à la direction de colonne de buse, et éjection d'une gouttelette d'une encre à partir d'une buse sur un tableau (10) comme support d'impression, la méthode comprenant et **caractérisée en ce que** :
utiliser une encre ayant un rapport de η2/η1 égal ou supérieur à 100, le η1 étant une viscosité à une température à l'éjection, le η2 étant une viscosité à une température à l'atterrissage ;
plusieurs fois d'atterrissage de la gouttelette de l'encre qui est utilisée pour former une couche de revêtement d'un point constituant le motif à former sur le tableau, et
contrôler la position du point où la gouttelette atterrit afin de ne pas avoir une certaine périodicité dans une direction principale de balayage ou dans une sous-direction de balayage du dispositif d'éjection d'encre (9), et afin de ne pas être successif dans la direction principale de balayage,
dans laquelle du contrôle est fait de sorte qu'une quantité liquide d'un point formant une surface de bord extérieur à une frontière entre un intérieur et un extérieur d'une surface de fond d'une partie convexe du tableau (10) varie continuellement d'une surface en contact avec la partie convexe à une surface dans une direction extérieure, et une épaisseur moyenne de la couche de revêtement du point constituant le motif est de 15 µm ou plus.

4. La méthode de formation de motif selon la revendication 3, dans laquelle
les données d'image du motif sont divisées en plusieurs parties, de sorte que des pixels ne se chevauchent pas lorsqu'ils sont surimprimés, et de sorte qu'une position du point où la gouttelette atterrit n'a pas une certaine périodicité dans la direction principale de balayage ou dans la sous-direction de balayage du dispositif d'éjection d'encre (9), et n'est pas successive dans la direction principale de balayage, et
les données d'image divisées sont surimprimées séquentiellement.

5. La méthode de formation de motif selon la revendication 3 ou la revendication 4, dans laquelle
le dispositif d'éjection d'encre (9) se déplace relativement vers l'avant et vers l'arrière dans la direction de balayage principale et éjecte une gouttelette d'encre à la fois dans un passage vers l'avant et dans un passage vers l'arrière.

6. La méthode de formation de motif selon l'une quelconque de la revendication 3 à la revendication 5, dans laquelle
le dispositif d'éjection d'encre (9) se déplace relativement dans une combinaison de direction vers l'avant et d'une direction opposée par rapport à la sous-direction de balayage.

7. La méthode de formation de motif selon l'une quelconque de la revendication 3 à la revendication 6, dans laquelle
une quantité liquide de l'encre qui est utilisée pour former la couche de revêtement du point constituant le motif à former sur le tableau (10) est contrôlée, correspondant à la teinte ou à la densité de chaque pixel constituant les données d'image du motif, afin de ne pas avoir une certaine périodicité avec des points voisins, et de sorte que la couche de revêtement du motif n'est pas entièrement à égalité.

8. La méthode de formation de motif selon l'une quelconque de la revendication 1 à la revendication 7, dans laquelle
du contrôle est fait de sorte qu'une quantité liquide de l'encre par point formant un bord intérieur d'une partie à motif, à une frontière entre une partie à motif et une partie ne pas à motif, formée sur le tableau (10) est essentiellement la même.

9. La méthode de formation de motif selon l'une quelconque de la revendication 1 à la revendication 8, dans laquelle
du contrôle est fait de sorte qu'une quantité liquide de l'encre par point formant un bord extérieur d'une frontière entre un intérieur et un extérieur d'un fond d'une partie convexe du tableau (10) est supérieure à une quantité liquide de l'encre par point formant un bord de la partie convexe.

10. La méthode de formation de motif selon l'une quelconque de la revendication 1 à la revendication 9, dans laquelle
une quantité liquide de l'encre qui atterrit et forme une couche de revêtement du point constituant le motif est modifiée dans multiples niveaux.

11. La méthode de formation de motif selon l'une quelconque de la revendication 1 à la revendication 10, dans laquelle
l'encre est l'une d'une encre de type thermofusible, d'une encre de type gélifié et d'une encre de type thixotrope.

12. La méthode de formation de motif selon l'une quelconque de la revendication 1 à la revendication 11, dans laquelle
l'encre est une encre résistante à la soudure.

13. Un dispositif d'impression jet d'encre (1) qui forme un motif basé sur des données d'image d'un motif en utilisant la méthode de formation de motif selon l'une quelconque de la revendication 1 à la revendication 12.
